# EUROPEAN PATENT APPLICATION

(11) **EP 4 844 042 A1**
(43) Date of publication of application: **25.11.2026**
(21) Application number: 25742095.0
(22) Date of filing: 14.01.2025
(51) Int. Cl.: C09K 11/02, C09K 11/62, C09K 11/56, H10K 59/38, H10K 50/805, H10K 77/10, G09F 9/30

(54) **QUANTUM DOT COMPOSITE, QUANTUM DOT COMPOSITION COMPRISING SAME, AND ELECTRONIC DEVICE COMPRISING SAME**

(30) Priority: 19.01.2024 KR 20240008935
(71) Applicant: Samsung Display Co., Ltd., Yongin-si, Gyeonggi-do 17113 (KR)
(72) Inventor: JANG, Seung Hee, Yongin-si Gyeonggi-do 17113 (KR); KIM, Sung Jae, Yongin-si Gyeonggi-do 17113 (KR); KIM, Young Sik, Yongin-si Gyeonggi-do 17113 (KR); YOON, Bit Na, Yongin-si Gyeonggi-do 17113 (KR); LEE, Dong Hee, Yongin-si Gyeonggi-do 17113 (KR); LEE, Taek Joon, Yongin-si Gyeonggi-do 17113 (KR); JUNG, June Hyuk, Yongin-si Gyeonggi-do 17113 (KR)
(74) Representative: Crow, Martin
(86) International application number: PCT/KR2025/000841
(87) International publication number: WO 2025/155080

(57) **Abstract**

Embodiments provide a quantum dot complex. The quantum dot complex comprises a quantum dot, and a first ligand and a second ligand, which are each coordinated on a surface of the quantum dot. The first ligand is a chain-shaped bidentate ligand comprising an ethylene glycol group (-OCH₂CH₂O-), and the second ligand is a ligand comprising an acryloyl group (CH₂=CHC(=O)-) and an ethylene glycol group.

## Description

### Technical Field

Embodiments relate to a quantum dot complex, a quantum dot composition comprising the same, an electronic device comprising the quantum dot complex, and an electronic equipment comprising the quantum dot complex.

### Background Art

Quantum dots are nano crystals of a semiconductor material and are materials that exhibit a quantum confinement effect. When quantum dots receive light from an excitation source and reach an energy excited state, the quantum dots emit energy according to a corresponding energy band gap. Quantum dots of a same material may emit light having different wavelengths depending on the size of the quantum dots. Accordingly, the size of quantum dots may be adjusted to obtain light in a desired wavelength range and exhibit characteristics such as excellent color purity and high luminous efficiency. Therefore, quantum dots are applicable to various devices.

Quantum dots may be utilized as materials performing various optical functions (for example, a photoconversion function) of optical members. Quantum dots are nano-sized semiconductor nanocrystals, and can have different energy band gaps by controlling the size and composition of the nanocrystals, thereby emitting light of various emission wavelengths.

Optical members comprising such a quantum dot may have a thin film form, for example, a thin film form patterned for each subpixel. Such an optical member may also be used as a color conversion member of a device comprising various light sources.

However, the quantum dots are readily oxidized by moisture and oxygen, and when they are oxidized, the efficiency thereof is reduced.

This issue can be addressed by coordinating reactive ligands around quantum dots. However, it was difficult to effectively prevent oxidation of quantum dots due to desorption and rearrangement of the ligands.

### Disclosure of Invention

### Technical Problem

Embodiments comprise a quantum dot complex with improved photostability, a quantum dot composition comprising the same, an electronic device comprising the same, and an electronic equipment comprising the same.

### Solution to Problem

According to embodiments, a quantum dot complex may comprise: a quantum dot; and a first ligand and a second ligand, each coordinated on a surface of the quantum dot, wherein
the first ligand may be a chain-shaped bidentate ligand comprising an ethylene glycol group (-OCH₂CH₂O-), and the second ligand may be a ligand comprising an acryloyl group (CH₂=CHC(=O)-) and an ethylene glycol group.

In an embodiment, the first ligand may be represented by Formula 1:

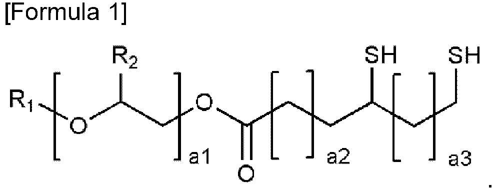

In Formula 1,
R₁ may be a C₁-C₂ alkyl group,
R₂ may each independently be hydrogen or a C₁-C₂ alkyl group,
a1 may be an integer from 2 to 4,
a2 may be an integer from 0 to 3, and
a3 may be an integer of 1 or 2.

In an embodiment, R₁ may be a methyl group; and R₂ may each independently be hydrogen or a methyl group.

In an embodiment, R₁ may be a methyl group; and R₂ may each be hydrogen.

In an embodiment, R₁ and R₂ may each be a methyl group.

In an embodiment, a1 may be 2 or 3.

In an embodiment, a2 may be 3; and a3 may be 1.

In an embodiment, the first ligand may be selected from the following compounds:

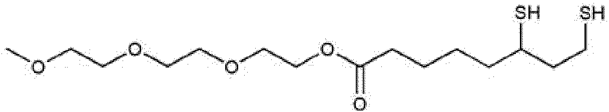

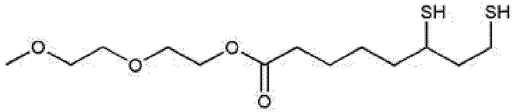

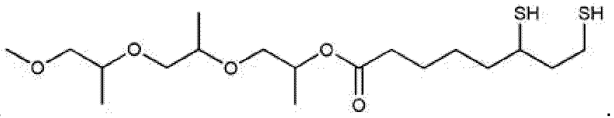

In an embodiment, the second ligand may further comprise a carboxylate group (-C(=O)OH); and the second ligand may be coordinated on the surface of the quantum dot by the carboxylate group.

In an embodiment, the second ligand may be the following compound:

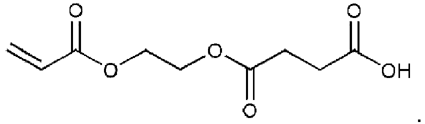

In an embodiment, a total amount of the first ligand and the second ligand may be in a range of about 15 wt% to about 25 wt%, based on a total weight of quantum dot complex.

In an embodiment, a molar ratio of the first ligand to the second ligand may be in a range of about 0.3:1 to about 0.8:1.

In an embodiment, the quantum dot may comprise: a Group II-VI semiconductor compound; a Group III-V semiconductor compound; a Group III-VI semiconductor compound; a Group I-III-VI semiconductor compound; a Group IV-VI semiconductor compound; a Group IV element or compound; or a combination thereof.

In an embodiment, the quantum dot may comprise a core, and a shell covering the core.

In an embodiment, the quantum dot may comprise a copper indium gallium sulfide (CIGS) core, and a ZnS shell.

According to embodiments, a quantum dot composition may comprise the quantum dot complex, and a solvent.

According to embodiments, an electronic device may comprise the quantum dot complex.

In an embodiment, the electronic device may further comprise a color filter and/or a color conversion layer, wherein the color filter and/or the color conversion layer may comprise the quantum dot complex.

In an embodiment, the electronic device may further comprise a light source, wherein the light source may be a light-emitting device comprising a first electrode, a second electrode facing the first electrode, and an emission layer between the first electrode and the second electrode.

According to embodiments, an electronic equipment may comprise the electronic device, wherein the electronic equipment may be a flat panel display, a curved display, a computer monitor, a medical monitor, a television, an advertisement board, an indoor light, an outdoor light, a signal light, a head-up display, a fully transparent display, a partially transparent display, a flexible display, a rollable display, a foldable display, a stretchable display, a laser printer, a telephone, a mobile phone, a tablet computer, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall comprising multiple displays tiled together, a theater screen, a stadium screen, a phototherapy device, or a signboard.

### Advantageous Effects of Invention

The quantum dot complex according to an embodiment has improved light resistance due to the introduction of a first ligand and a second ligand on the surface of the quantum dot, thereby improving the efficiency and lifespan of an electronic apparatus using the quantum dot complex.

### Brief Description of Drawings

FIG. 1 is a schematic cross-sectional view of a light-emitting device according to an embodiment.
FIGS. 2 and 3 are each a schematic cross-sectional view of an electronic device according to embodiments.
FIG. 4 is a graph showing the change in light conversion efficiency of the quantum dot complexes of Experimental Examples 1 to 7 over time.
FIG. 5 is a graph showing the change in light conversion efficiency of the quantum dot complexes of Examples 1 to 3 and Comparative Examples 1 to 3 over time.
FIG. 6 is a graph showing the change in the light conversion efficiency of the quantum dot complexes of Examples 4 to 6 and Comparative Examples 4 to 6 over time.
FIG. 7 is a thermogravimetric analysis graph for the CIGS quantum dot complexes obtained in Experimental Examples 1 and 4, Examples 2 and 5, and Comparative Example 5.

### Best Mode for Carrying out the Invention

As the disclosure allows for various changes and numerous embodiments, illustrative embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

In the specification, the expressions used in the singular such as "a", "an", and "the" are intended to comprise the plural forms as well, unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

One or more embodiments will be described below in more detail with reference to the accompanying drawings. Those components that are the same as or are in correspondence with each other are rendered the same reference numeral regardless of the figure number, and redundant explanations are omitted.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

In the specification, the term "quantum dot complex" may refer to a material that comprises a quantum dot and a ligand that is coordinated to the quantum dot. The quantum dot may comprise a core and a shell surrounding the core.

In the specification, the term "photo conversion efficiency (PCE)" may refer to a ratio of fluorescent photons to excitation photons.

### [Quantum dot complex]

According to embodiments, a quantum dot complex may comprise: a quantum dot; and a first ligand and a second ligand, each coordinated on a surface of the quantum dot. The first ligand may be a chain-shaped bidentate ligand comprising an ethylene glycol group (-OCH₂CH₂O-), and the second ligand may be a ligand comprising an acryloyl group (CH₂=CHC(=O)-) and an ethylene glycol group.

Quantum dot ligands may protect quantum dots and may allow quantum dots to be evenly dispersed in a solvent. In order to perform these functions, a quantum dot ligand according to an embodiment may comprise two types of ligands with different structures.

In an embodiment, the first ligand may be represented by Formula 1:

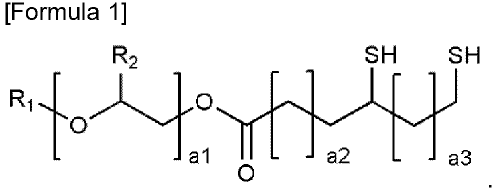

In Formula 1,
R₁ may be a C₁-C₂ alkyl group,
R₂ may each independently be hydrogen or a C₁-C₂ alkyl group,
a1 may be an integer from 2 to 4,
a2 may be an integer from 0 to 3, and
a3 may be an integer of 1 or 2.

In an embodiment, R₁ may be a methyl group or an ethyl group, and R₂ may each be hydrogen. For example, in an embodiment, R₁ may be a methyl group, and R₂ may each be hydrogen.

In an embodiment, R₁ may be a methyl group or an ethyl group, and R₂ may each independently be hydrogen or a methyl group. For example, in an embodiment, R₁ may be a methyl group, and R₂ may independently be hydrogen or a methyl group.

In an embodiment, R₁ and R₂ may each be a methyl group.

In an embodiment, a1 may be 2 or 3.

In an embodiment, a2 may be 3.

In an embodiment, a3 may be 1.

For example, in an embodiment, a1 may be 2 or 3, a2 may be 3, and a3 may be 1.

In an embodiment, the first ligand may be selected from the following compounds:

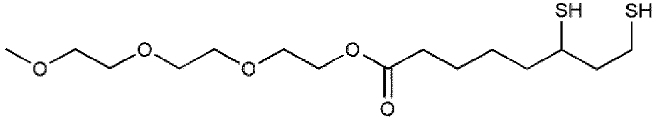

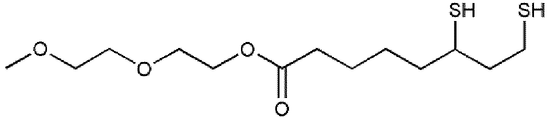

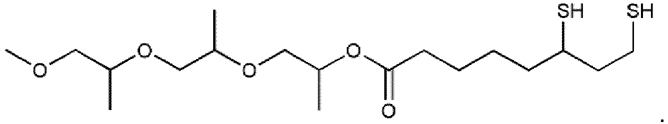

The first ligand has a chain structure that comprises an ethylene glycol group (-OCH₂CH₂O-), thereby increasing the solubility of the quantum dot in a hydrophilic solvent and minimizing contact between the quantum dot and an external source that can oxidize the quantum dot. The first ligand may form a more stable bond to the quantum dot by coordinating onto the quantum dot at two sites. With respect to the first ligand, due to the inclusion of a short alkoxy group at the end of the chain, greater polarity may be obtained than from a ligand of having an aryloxy group or a long alkoxy group at the end of the chain. In an embodiment, a hydrogen atom in the ethylene glycol group of the first ligand may be substituted with a short alkyl group.

The second ligand may increase the dispersibility of the quantum dot complex in a hydrophilic solvent due to the inclusion of an acryloyl group (CH₂=CHC(=O)-) and an ethylene glycol group. When the quantum dot complex is evenly dispersed in a solvent, stress caused by light may also be dispersed, which can improve light resistance of a quantum dot complex film.

In an embodiment, the second ligand may further comprise a carboxylate group (-C(=O)OH), and the second ligand may be coordinated on a surface of the quantum dot by the carboxylate group. The second ligand may improve photostability by coordinating onto a surface of the quantum dot by a carboxylate group.

In an embodiment, the second ligand may comprise the following compound:

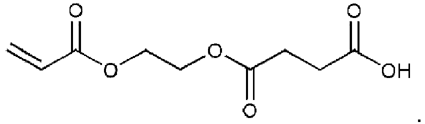

The quantum dot complex according to an embodiment may have improved light resistance due to the inclusion of both the first ligand and the second ligand. This is believed to be due to achieving a balance between strengthening the binding of the ligands to the quantum dot and improving the dispersibility of the ligands in the solvent.

In an embodiment, a total amount of the first ligand and the second ligand in the quantum dot complex may be in a range of about 15 wt% to about 25 wt%, based on a total weight of the quantum dot complex. For example, in the quantum dot complex, a sum of a total amount of the first ligand, and a total amount of the second ligand may be in a range of about 15 wt% to about 25 wt%, based on a total weight of the quantum dot complex. When the total amount of the first ligand and the second ligand is within the range above, light resistance of the quantum dot complex may be improved. The first ligand and the second ligand may be introduced into the quantum dot complex by exchanging with a native ligand. In an embodiment, the native ligand of the quantum dot complex may comprise, for example, oleic acid, lauric acid, or stearic acid, but embodiments are not limited thereto.

In an embodiment, a molar ratio of the first ligand to the second ligand may be in a range of about 0.3:1 to about 0.8:1. When the molar ratio of the first ligand to the second ligand is within this range, light resistance of the quantum dot complex may be improved. In an embodiment, the quantum dot may have a core-shell structure that comprises a core comprising a semiconductor compound and a shell comprising a semiconductor compound.

In an embodiment, the quantum dot may comprise: a Group II-VI semiconductor compound; a Group III-V semiconductor compound; a Group III-VI semiconductor compound; a Group I-III-VI semiconductor compound; a Group IV-VI semiconductor compound; a Group IV element or compound; or a combination thereof.

Examples of a Group II-VI semiconductor compound may comprise: a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or a combination thereof.

Examples of a Group III-V semiconductor compound may comprise: a binary compound, such as GaN, GaP, GaAs, GaSb, AlN, AlP, AlAs, AlSb, InN, InP, InAs, InSb, and the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and the like; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and the like; or any combination thereof. In an embodiment, a Group III-V semiconductor compound may further comprise a Group II element. Examples of a Group III-V semiconductor compound further comprising a Group II element may comprise InZnP, InGaZnP, InAlZnP, etc.

Examples of a Group III-VI semiconductor compound may comprise: a binary compound, such as GaS, GaSe, Ga₂Se₃, GaTe, InS, InSe, In₂S₃, In₂Se₃, or InTe; a ternary compound, such as InGaS₃, or InGaSe₃; or a combination thereof.

Examples of a Group I-III-VI semiconductor compound may comprise: a ternary compound such as AgInS, AgInS₂, CuInS, CuInS₂, CuGaO₂, AgGaO₂, or AgAlO₂; a quaternary compound such as AgInGaS or AgInGaS₂; or a combination thereof.

Examples of a Group IV-VI semiconductor compound may comprise: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or a combination thereof.

Examples of a Group IV element or compound may comprise: a single element material, such as Si or Ge; a binary compound, such as SiC or SiGe; or a combination thereof.

Each element comprised in a compound such as a binary compound, a ternary compound, or a quaternary compound may be present in a particle at a uniform concentration or at a non-uniform concentration.

In an embodiment, examples of a semiconductor compound comprised in the shell may comprise CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or a combination thereof.

In an embodiment, the quantum dot may comprise a copper indium gallium sulfide (CIGS) core and a ZnS or GaS shell.

In embodiments, a quantum dot may be in the form of a spherical particle, a pyramidal particle, a multi-arm particle, a cubic nanoparticle, a nanotube particle, a nanowire particle, a nanofiber particle, or a nanoplate particle.

Since the energy band gap can be controlled by adjusting the size of a quantum dot, a light-emitting device that emits light of various wavelengths may be implemented by using quantum dots of different sizes. For example, the size of the quantum dot may be selected to emit red light or green light. In an embodiment, the size of the quantum dot may be configured to emit white light by a combination of light of various colors.

### [Quantum dot composition]

According to embodiments, a quantum dot composition may comprise the quantum dot complex.

In an embodiment, the quantum dot composition may comprise a quantum dot complex, a crosslinkable monomer, and an initiator.

The crosslinkable monomer may be, for example, an acrylic monomer. The crosslinkable monomer may comprise, for example,1,6-hexanediol diacrylate, 2-ethylhexyl(meth)acrylate, ethyl(meth)acrylate, methyl(meth)acrylate, n-propyl(meth)acrylate, isopropyl(meth)acrylate, pentyl(meth)acrylate, n-octyl(meth)acrylate, isooctyl(meth)acrylate, isononyl(meth)acrylate, n-butyl(meth)acrylate, isobutyl(meth)acrylate, n-hexyl(meth)acrylate, n-nonyl(meth)acrylate, isoamyl(meth)acrylate, n-decyl(meth)acrylate, isodecyl(meth)acrylate, dodecyl(meth)acrylate, isobornyl(meth)acrylate, cyclohexyl(meth)acrylate, phenyl(meth)acrylate, benzyl(meth)acrylate, isostearyl(meth)acrylate, 2-methylbutyl(meth)acrylate, or a combination thereof.

The initiator may comprise, for example, diphenyl(2,4,6-trimethylbenzoyl)phosphine oxide, 4-acryloxybenzophenone, 2,2-dimethoxy-2-phenylacetophenone, 2-hydroxy-2-methyl-1-phenyl- 1-propan-1-one, ethyl(2,4,6-trimethylbenzoyl)phenyl phosphinate, bisacylphosphine oxide, or a combination thereof.

In an embodiment, the quantum dot composition may further comprise an additive, in addition to the crosslinkable monomer and the initiator. The additive may comprise, for example, a material to increase photostability, thermal stability, or storage stability of the quantum dot complex. The additive may comprise, for example, ultraviolet (UV) stabilizers, heat stabilizers, or reaction inhibitors.

In an embodiment, the quantum dot composition may comprise the quantum dot complex and a solvent.

In an embodiment, the solvent may be hydrophobic or hydrophilic.

In an embodiment, the hydrophobic solvent may comprise at least one of an aliphatic hydrocarbon system and an aromatic hydrocarbon system.

For example, the hydrophobic solvent may comprise at least one of: an alkane such as n-pentane, n-hexane, n-heptane, n-octane, n-nonane, n-decane, dodecane, hexadecane, and oxadecane; a haloalkane such as dichloromethane, 1,2-dichloroethane, and 1,1,2-trichloroethane; a cycloalkane such as cyclohexane, methylcyclohexane, etc.; an aromatic hydrocarbon such as toluene, xylene, mesitylene, ethylbenzene, n-hexylbenzene, cyclohexylbenzene, trimethylbenzene, and tetrahydronaphthalene; and an aryl halide such as chlorobenzene, o-dichlorobenzene, and cyclohexylbenzene.

In an embodiment, the hydrophilic solvent may comprise at least one of an alcohol group, an ether group, a ketone group, and an ester group.

For example, the hydrophilic solvent may comprise at least one of: a alkylene glycol alkyl ether such as ethylene glycol monomethyl ether, ethylene glycol monoethyl ether, ethylene glycol monopropyl ether, ethylene glycol monobutyl ether, propylene glycol monomethyl ether, and propylene glycol methyl ethyl ether; a diethylene glycol dialkyl ether such as diethylene glycol dimethyl ether, diethylene glycol diethyl ether, diethylene glycol dipropyl ether, and diethylene glycol dibutyl ether; an alkylene glycol alkyl ether acetate such as methyl cellosolve acetate, ethyl cellosolve acetate, propylene glycol monomethyl ether acetate, propylene glycol monoethyl ether acetate, and propylene glycol monopropyl ether acetate; an alkoxyalkyl acetate such as methoxybutyl acetate and methoxypentyl acetate; an aromatic hydrocarbon such as benzene, toluene, xylene, and mesitylene; a ketone such as methyl ethyl ketone, acetone, methyl amyl ketone, methyl isobutyl ketone, and cyclohexanone; an alcohol such as ethanol, propanol, butanol, hexanol, cyclohexanol, ethylene glycol, and glycerin; an ester such as 3-ethoxypropionic acid ethyl ester, 3-methoxypropionic acid methyl ester, and 3-phenylpropionic acid ethyl ester; a cyclic ester such as γ-butyrolactone; and methoxybenzene (anisole).

In an embodiment, a viscosity (@25 °C) of the composition may be in a range of about 2 cP to about 30 cP.

When the viscosity is within this range, the composition according to an embodiment may be suitable for forming a layer using a solution process, for example, by a spin coating process or an inkjet process.

### [Light-emitting device]

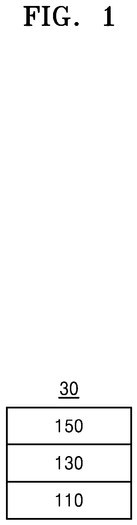

### [Description of FIG. 1]

FIG. 1 is a schematic cross-sectional view of a light-emitting device 10 according to an embodiment. The light-emitting device 10 may comprise a first electrode 110, an interlayer 130, and a second electrode 150.

Hereinafter, the structure and a manufacturing method of the light-emitting device 10 according to an embodiment will be described with reference to FIG. 1.

### [First electrode 110]

In FIG. 1, a substrate may be further comprised under the first electrode 110 or on the second electrode 150. The substrate may be a glass substrate or a plastic substrate. In an embodiment, the substrate may be a flexible substrate and may comprise plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a transflective electrode, or a transmissive electrode. When the first electrode 110 is a transmissive electrode, a material for forming the first electrode 110 may comprise indium tin oxide (ITO), indium zinc oxide (IZO), tin oxide (SnO₂), zinc oxide (ZnO), or any combination thereof. In an embodiment, when the first electrode 110 is a transflective electrode or a reflective electrode, a material for forming the first electrode 110 may comprise magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a structure consisting of a single layer or a structure comprising multiple layers. In an embodiment, the first electrode 110 may have a three-layer structure of ITO/Ag/ITO.

### [Interlayer 130]

The interlayer 130 may be disposed above the first electrode 110. The interlayer 130 may comprise an emission layer.

The interlayer 130 may further comprise a hole transport region between the first electrode 110 and the emission layer, and an electron transport region between the emission layer and the second electrode 150.

The interlayer 130 may further comprise, in addition to various organic materials, a metal-containing compound such as an organometallic compound, an inorganic material such as quantum dots, or the like.

In an embodiment, the interlayer 130 may comprise two or more emitting units stacked between the first electrode 110 and the second electrode 150, and at least one charge generation layer between adjacent units among the two or more emitting units. When the interlayer 130 comprises two or more emitting units and the at least one charge generation layer as described above, the light-emitting device 10 may be a tandem light-emitting device.

### [Hole transport region in interlayer 130]

The hole transport region may have a structure consisting of a layer consisting of a single material, a structure consisting of a layer comprising different materials, or a structure comprising multiple layers comprising different materials.

The hole transport region may comprise a hole injection layer, a hole transport layer, an emission auxiliary layer, an electron-blocking layer, or any combination thereof.

In an embodiment, the hole transport region may have a multi-layer structure comprising a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein the layers of each structure may be stacked from the first electrode 110 in its respective stated order, but the structure of the hole transport region is not limited thereto.

In embodiments, the hole transport region may comprise a compound represented by Formula 201, a compound represented by Formula 202, or any combination thereof:

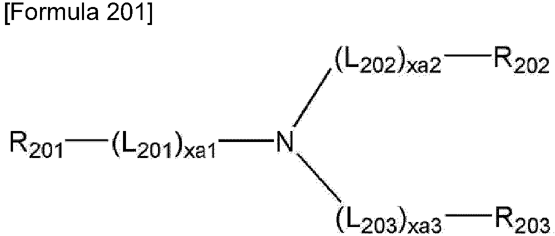

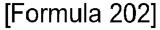

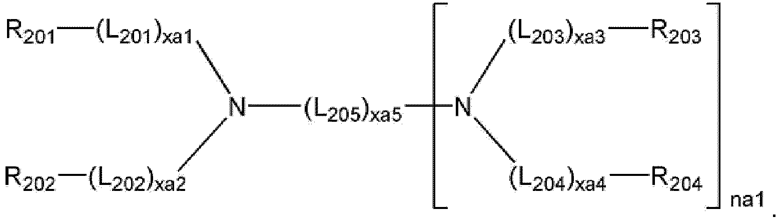

In Formulae 201 and 202,
L₂₀₁ to L₂₀₄ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R10a,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₂₀₁ and R₂₀₂ may be optionally linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group (for example, a carbazole group) that is unsubstituted or substituted with at least one R₁₀ₐ (for example, Compound HT16),
R₂₀₃ and R₂₀₄ may be optionally linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group that is unsubstituted or substituted with at least one R₁₀ₐ, and
na1 may be an integer from 1 to 4.

In an embodiment, the compound represented by Formula 201 and the compound represented by Formula 202 may each independently comprise at least one of groups represented by Formulae CY201 to CY217:

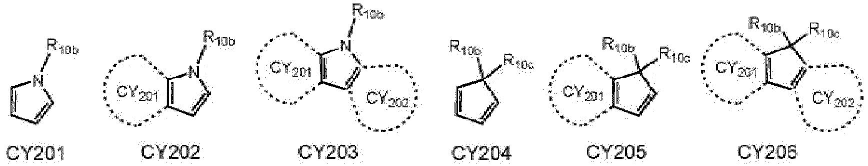

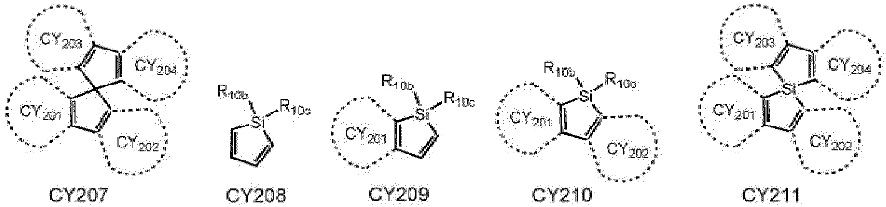

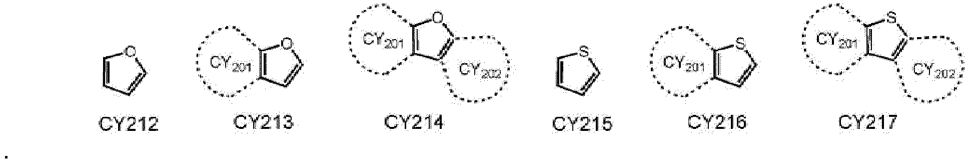

In Formulae CY201 to CY217, R_{10b} and R_{10c} may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ which is described herein.

In an embodiment, in Formulae CY201 to CY217, ring CY₂₀₁ to ring CY₂₀₄ may each independently be a benzene group, a naphthalene group, a phenanthrene group, or an anthracene group.

In an embodiment, the compound represented by Formula 201 and the compound represented by Formula 202 may each independently comprise at least one of groups represented by Formulae CY201 to CY203.

In an embodiment, the compound represented by Formula 201 may comprise at least one of groups represented by Formulae CY201 to CY203 and at least one of groups represented by Formulae CY204 to CY217.

In an embodiment, in Formula 201, xa1 may be 1, R₂₀₁ may be a group represented by one of Formulae CY201 to CY203, xa2 may be 0, and R₂₀₂ may be a group represented by one of Formulae CY204 to CY207.

In an embodiment, the compound represented by Formula 201 and the compound represented by Formula 202 may each not comprise groups represented by Formulae CY201 to CY203.

In an embodiment, the compound represented by Formula 201 and the compound represented by Formula 202 may each not comprise groups represented by Formulae CY201 to CY203 and may each independently comprise at least one of groups represented by Formulae CY204 to CY217.

In an embodiment, the compound represented by Formula 201 and the compound represented by Formula 202 may each not comprise groups represented by Formulae CY201 to CY217.

In an embodiment, the hole transport region may comprise one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

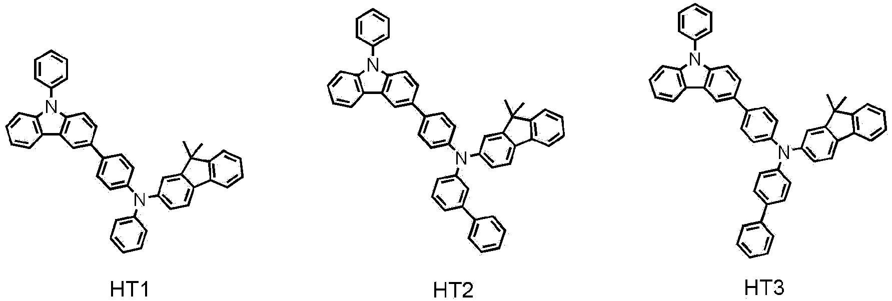

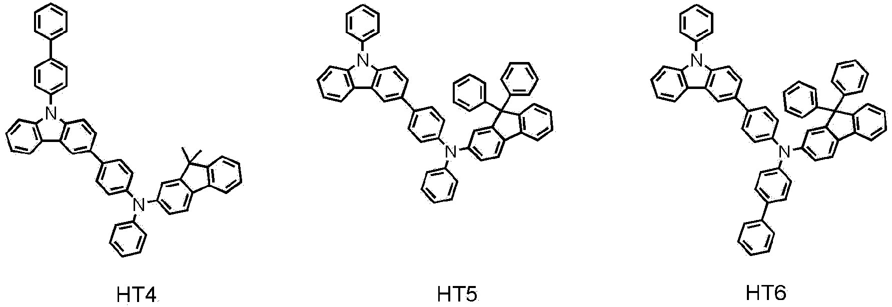

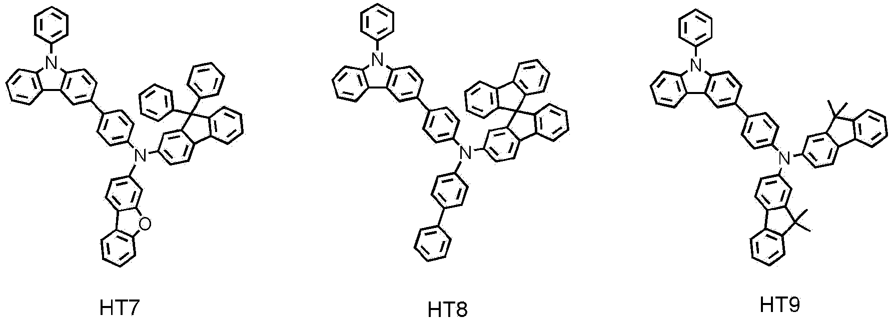

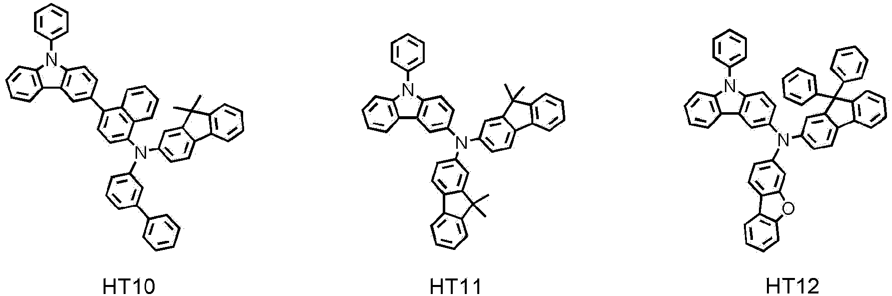

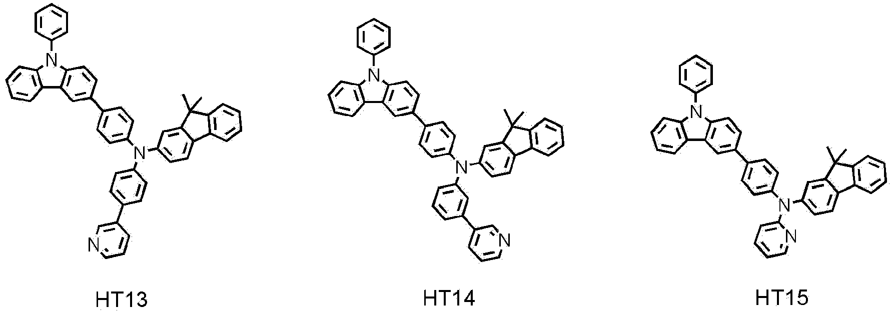

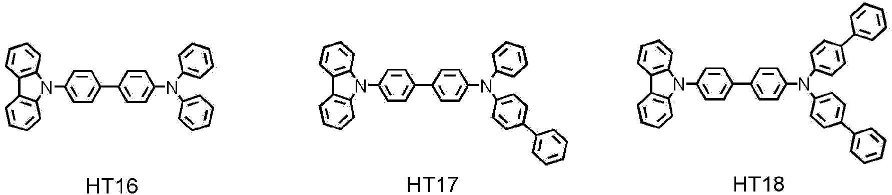

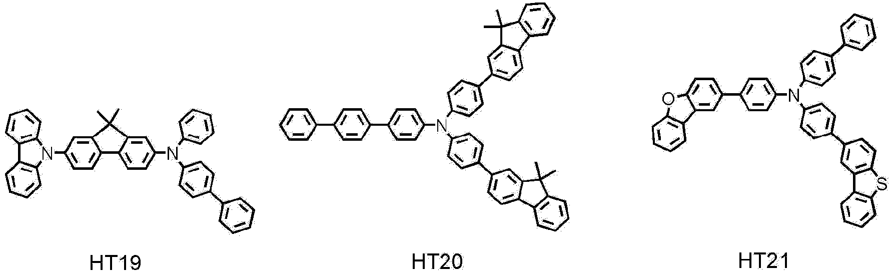

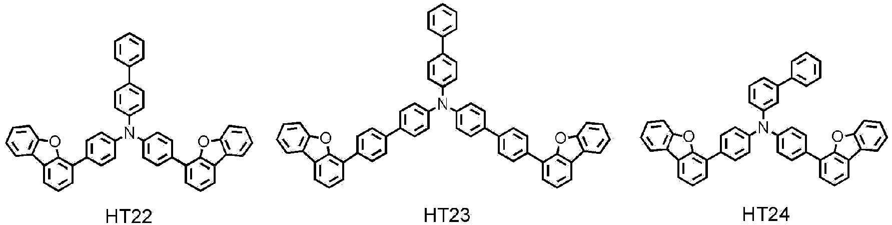

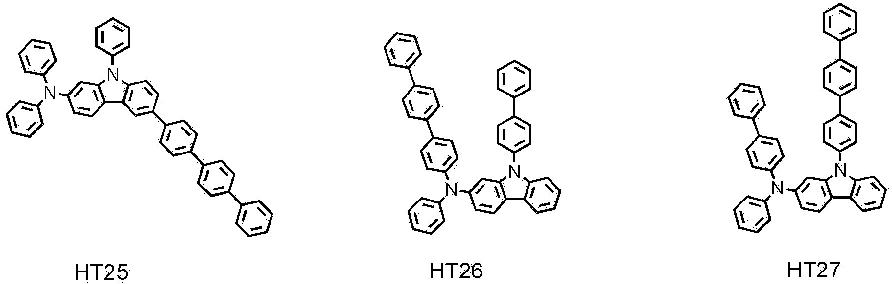

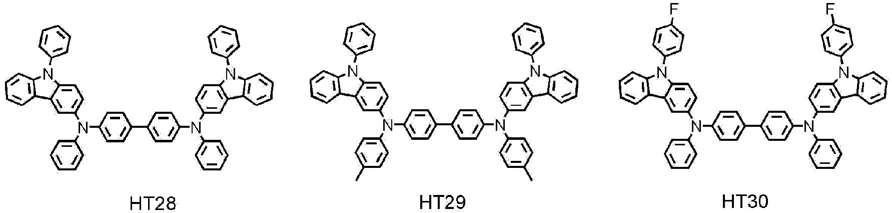

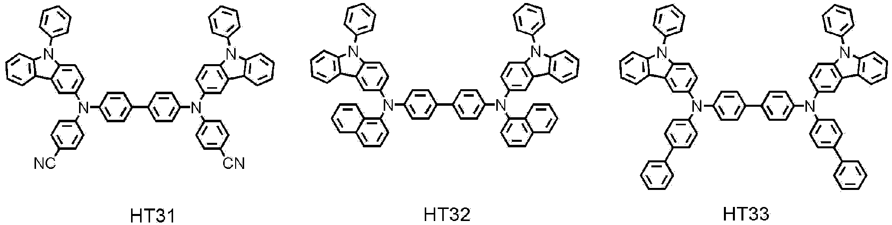

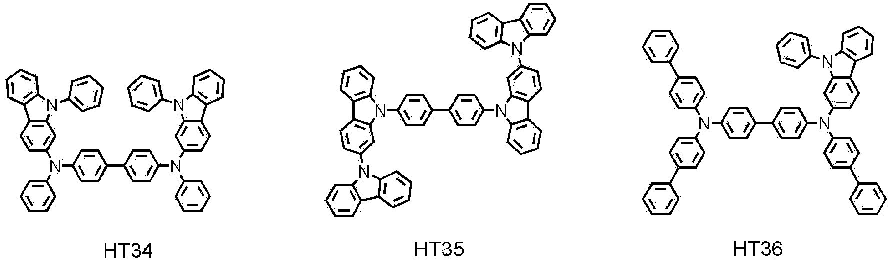

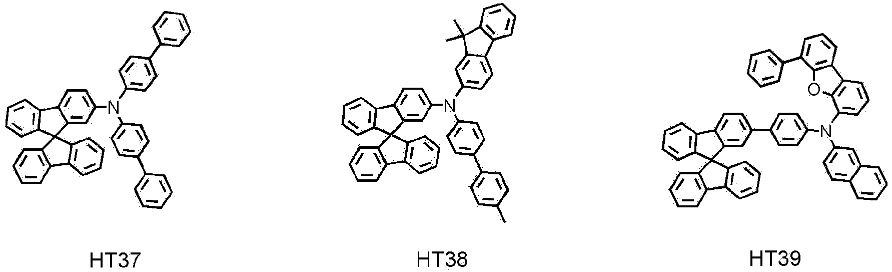

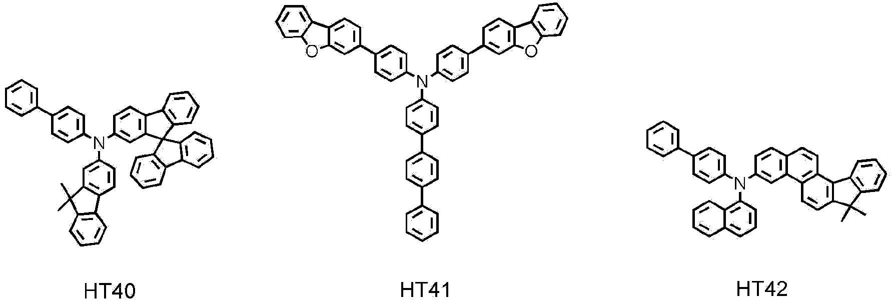

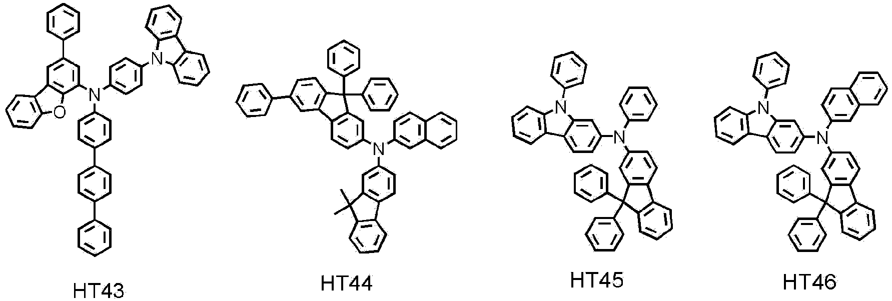

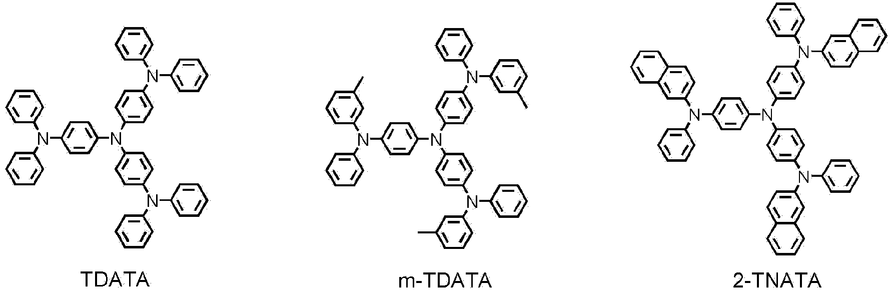

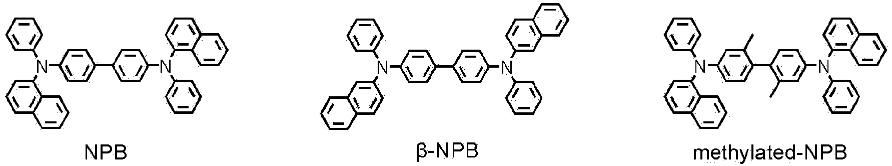

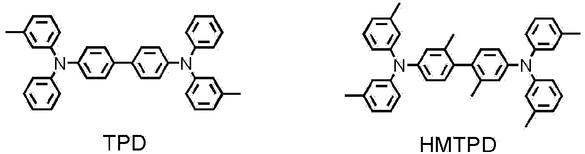

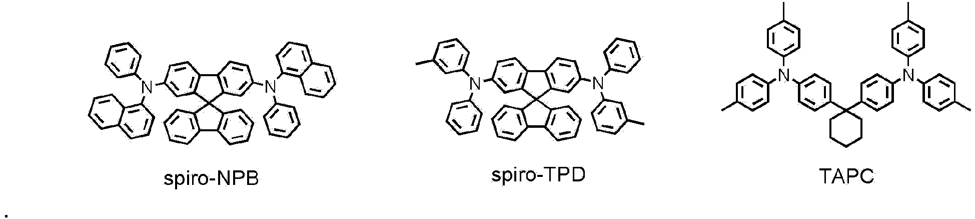

A thickness of the hole transport region may be in a range of about 50 Å to about 10,000 Å. For example, the thickness of the hole transport region may be in a range of about 100 Å to about 4,000 Å. When the hole transport region comprises a hole injection layer, a hole transport layer, or a combination thereof, a thickness of the hole injection layer may be in a range of about 50 Å to about 9,000 Å, and a thickness of the hole transport layer may be in a range of about 50 Å to about 2,000 Å. For example, the thickness of the hole injection layer may be in a range of about 100 Å to about 1,000 Å. For example, the thickness of the hole transport layer may be in a range of about 100 Å to about 1,500 Å. When the thicknesses of the hole transport region, the hole injection layer, and the hole transport layer are within the ranges described above, satisfactory hole transporting characteristics may be obtained without a substantial increase in driving voltage.

The emission auxiliary layer may increase light-emission efficiency by compensating for an optical resonance distance of a wavelength of light emitted by an emission layer, and the electron-blocking layer may block the leakage of electrons from an emission layer to a hole transport region. Materials that may be comprised in the hole transport region may be comprised in the emission auxiliary layer and the electron-blocking layer.

### [p-dopant]

The hole transport region may further comprise, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, a lowest unoccupied molecular orbital (LUMO) energy level of the p-dopant may be equal to or less than about -3.5 eV.

In an embodiment, the p-dopant may comprise a quinone derivative, a cyano group-containing compound, a compound comprising element EL1 and element EL2, or a combination thereof.

Examples of a quinone derivative may comprise TCNQ and F4-TCNQ.

Examples of a cyano group-containing compound may comprise HAT-CN and a compound represented by Formula 221:

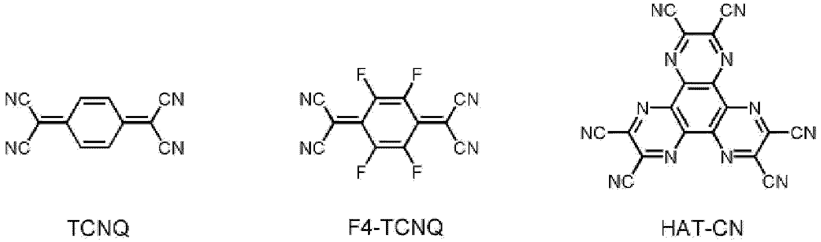

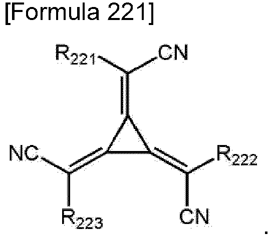

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or a combination thereof.

In the compound comprising element EL1 and the element EL2, element EL1 may be a metal, a metalloid, or a combination thereof, and element EL2 may be a non-metal, a metalloid, or a combination thereof.

Examples of a metal may comprise: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of a metalloid may comprise silicon (Si), antimony (Sb), and tellurium (Te).

Examples of a non-metal may comprise oxygen (O) and a halogen (for example, F, Cl, Br, I, etc.).

Examples of a compound comprising element EL1 and element EL2 may comprise a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, or a combination thereof.

Examples of a metal oxide may comprise a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (MoO, Mo₂O₃, MoO₂, MoO₃, Mo₂O₅, etc.), and a rhenium oxide (for example, ReO₃, etc.).

Examples of a metal halide may comprise an alkali metal halide, an alkaline earth metal halide, a transition metal halide, a post-transition metal halide, and a lanthanide metal halide.

Examples of an alkali metal halide may comprise LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of an alkaline earth metal halide may comprise BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of a transition metal halide may comprise a titanium halide (for example, TiF₄, TiCl₄, TiBr₄, TiI₄, etc.), a zirconium halide (for example, ZrF₄, ZrCl₄, ZrBr₄, ZrI₄, etc.), a hafnium halide (for example, HfF₄, HfCl₄, HfBr₄, HfI₄, etc.), a vanadium halide (for example, VF₃, VCl₃, VBr₃, VI₃, etc.), a niobium halide (for example, NbF₃, NbCl₃, NbBr₃, NbI₃, etc.), a tantalum halide (for example, TaF₃, TaCl₃, TaBr₃, TaI₃, etc.), a chromium halide (for example, CrF₃, CrCl₃, CrBr₃, CrI₃, etc.), a molybdenum halide (for example, MoF₃, MoCl₃, MoBr₃, MoI₃, etc.), a tungsten halide (for example, WF₃, WCl₃, WBr₃, WI₃, etc.), a manganese halide (for example, MnF₂, MnCl₂, MnBr₂, MnI₂, etc.), a technetium halide (for example, TcF₂, TcCl₂, TcBr₂, TcI₂, etc.), a rhenium halide (for example, ReF₂, ReCl₂, ReBr₂, ReI₂, etc.), an iron halide (for example, FeF₂, FeCl₂, FeBr₂, FeI₂, etc.), a ruthenium halide (for example, RuF₂, RuCl₂, RuBr₂, RuI₂, etc.), an osmium halide (for example, OsF₂, OsCl₂, OsBr₂, OsI₂, etc.), a cobalt halide (for example, CoF₂, CoCl₂, CoBr₂, CoI₂, etc.), a rhodium halide (for example, RhF₂, RhCl₂, RhBr₂, RhI₂, etc.), an iridium halide (for example, IrF₂, IrCl₂, IrBr₂, IrI₂, etc.), a nickel halide (for example, NiF₂, NiCl₂, NiBr₂, NiI₂, etc.), a palladium halide (for example, PdF₂, PdCl₂, PdBr₂, PdI₂, etc.), a platinum halide (for example, PtF₂, PtCl₂, PtBr₂, PtI₂, etc.), a copper halide (for example, CuF, CuCl, CuBr, CuI, etc.), a silver halide (for example, AgF, AgCl, AgBr, AgI, etc.), and a gold halide (for example, AuF, AuCl, AuBr, AuI, etc.).

Examples of a post-transition metal halide may comprise a zinc halide (for example, ZnF₂, ZnCl₂, ZnBr₂, ZnI₂, etc.), an indium halide (for example, InI₃, etc.), and a tin halide (for example, SnI₂, etc.).

Examples of a lanthanide metal halide may comprise YbF, YbF₂, YbF₃, SmF₃, YbCl, YbCl₂, YbCl₃ SmCl₃, YbBr, YbBr₂, YbBr₃, SmBr₃, YbI, YbI₂, YbI₃, and SmI₃.

Examples of a metalloid halide may comprise an antimony halide (for example, SbCl₅, etc.).

Examples of a metal telluride may comprise an alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### [Emission layer in interlayer 130]

When the light-emitting device 10 is a full-color light-emitting device, the emission layer may be patterned into a red emission layer, a green emission layer, and/or a blue emission layer, according to a subpixel. In an embodiment, the emission layer may have a stacked structure of two or more layers of a red emission layer, a green emission layer, and a blue emission layer, in which the two or more layers may contact each other or may be separated from each other, to emit white light. In embodiments, the emission layer may comprise two or more materials of a red light-emitting material, a green light-emitting material, and a blue light-emitting material, in which the two or more materials may be mixed with each other in a single layer, to emit white light.

The emission layer may comprise a host and a dopant. The dopant may comprise a phosphorescent dopant, a fluorescent dopant, or any combination thereof.

An amount of the dopant in the emission layer may be in a range of about 0.01 parts by weight to about 15 parts by weight, based on 100 parts by weight of the host.

In embodiments, the emission layer may comprise the quantum dot complex described above (hereinafter also referred to as "quantum dot").

In an embodiment, the emission layer may comprise a delayed fluorescence material. The delayed fluorescent material may serve as a host or as a dopant in the emission layer.

A thickness of the emission layer may be in a range of about 100 Å to about 1,000 Å. For example, the thickness of the emission layer may be in a range of about 200 Å to about 600 Å. When the thickness of the emission layer is within any of the ranges described above, excellent luminescence characteristics may be obtained without a substantial increase in driving voltage.

### [Quantum dot]

The emission layer may comprise a quantum dot.

In the specification, a quantum dot may be a crystal of a semiconductor compound, and may comprise any material capable of emitting light of various emission wavelengths according to a size of the crystal. Quantum dots may emit light of various emission wavelengths by adjusting a ratio of elements in a quantum dot compound.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process is a method that comprise mixing a precursor material with an organic solvent and growing a quantum dot crystal particle. When the crystal grows, the organic solvent naturally serves as a dispersant coordinated on the surface of the quantum dot crystal and controls the growth of the crystal. Accordingly, the growth of quantum dot particles can be controlled through a process which costs less and may be more readily performed than vapor deposition methods, such as metal organic chemical vapor deposition (MOCVD) or molecular beam epitaxy (MBE).

A quantum dot may comprise a Group II-VI semiconductor compound, a Group III-V semiconductor compound, a Group III-VI semiconductor compound, a Group I-III-VI semiconductor compound, a Group IV-VI semiconductor compound, a Group IV element or compound, or a combination thereof.

Examples of a Group II-VI semiconductor compound may comprise: a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or a combination thereof.

Examples of a Group III-V semiconductor compound may comprise: a binary compound, such as GaN, GaP, GaAs, GaSb, AlN, AlP, AlAs, AlSb, InN, InP, InAs, InSb, and the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and the like; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and the like; or a combination thereof. In an embodiment, a Group III-V semiconductor compound may further comprise a Group II element. Examples of a Group III-V semiconductor compound further comprising a Group II element may comprise InZnP, InGaZnP, InAlZnP, etc.

Examples of a Group III-VI semiconductor compound may comprise: a binary compound, such as GaS, GaSe, Ga₂Se₃, GaTe, InS, InSe, In₂S₃, In₂Se₃, or InTe; a ternary compound, such as InGaS₃, or InGaSe₃; or a combination thereof.

Examples of a Group I-III-VI semiconductor compound may comprise: a ternary compound such as AgInS, AgInS₂, CuInS, CuInS₂, CuGaO₂, AgGaO₂, or AgAlO₂; a quaternary compound such as AgInGaS or AgInGaS₂; or a combination thereof.

Examples of a Group IV-VI semiconductor compound may comprise: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or a combination thereof.

Examples of a Group IV element or compound may comprise: a single element material such as Si or Ge; a binary compound, such as SiC or SiGe; or a combination thereof.

Each element comprised in a compound, such as a binary compound, a ternary compound, or a quaternary compound, may be present in a quantum dot particle at a uniform concentration or at a non-uniform concentration.

In an embodiment, a quantum dot may have a single structure in which the concentration of each element in the quantum dot is uniform, or a quantum dot may have a core-shell structure. For example, a material comprised in the core and a material comprised in the shell may be different from each other.

The shell of a quantum dot may serve as a protective layer that prevents chemical degeneration of the core to maintain semiconductor characteristics, and/or may serve as a charging layer that imparts electrophoretic characteristics to the quantum dot. The shell may be a single layer or multilayered. An interface between the core and the shell may have a concentration gradient in which the concentration of an element that is present in the shell decreases toward the core.

A shell of a quantum dot may comprise a metal, a metalloid, a non-metal, a semiconductor compound, or a combination thereof. Examples of a metal oxide, a metalloid oxide, or a non-metal oxide may comprise: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; or a combination thereof.

Examples of a semiconductor compound may comprise, as described herein: a Group II-VI semiconductor compound; a Group III-V semiconductor compound; a Group III-VI semiconductor compound; a Group I-III-VI semiconductor compound; a Group IV-VI semiconductor compound; and a combination thereof. For example, the semiconductor compound may comprise CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or a combination thereof.

A full width at half maximum (FWHM) of an emission spectrum of the quantum dot may be equal to or less than about 45 nm. For example, a FWHM of an emission spectrum of the quantum dot may be equal to or less than about 40 nm. For example, a FWHM of an emission spectrum of the quantum dot may be equal to or less than about 30 nm. Within any of these ranges, color purity or color reproducibility may be improved. Light emitted through a quantum dot may be emitted in all directions, so that a wide viewing angle may be improved.

In embodiments, a quantum dot may be in the form of a spherical particle, a pyramidal particle, a multi-arm particle, a cubic nanoparticle, a nanotube particle, a nanowire particle, a nanofiber particle, or a nanoplate particle.

Since an energy band gap may be adjusted by controlling the size of the quantum dot, light having various wavelength bands may be obtained from a quantum dot emission layer. Accordingly, by using quantum dots of different sizes, a light-emitting device that emits light of various wavelengths may be implemented. In embodiments, the size of the quantum dot may be adjusted to emit red light, green light, and/or blue light. In an embodiment, the size of the quantum dot may be configured to emit white light by a combination of light of various colors.

### [Electron transport region in interlayer 130]

The electron transport region may have a structure consisting of a layer consisting of a single material, a structure consisting of a layer comprising different materials, or a structure comprising multiple layers comprising different materials.

The electron transport region may comprise a hole-blocking layer, an electron transport layer, an electron injection layer, or a combination thereof.

In an embodiment, the electron transport region may have a structure comprising an electron transport layer/electron injection layer structure or a hole-blocking layer/electron transport layer/electron injection layer structure, wherein the layers of each structure may be stacked from an emission layer in its respective stated order, but the structure of the electron transport region is not limited thereto.

The electron transport region (for example, a hole-blocking layer or an electron transport layer in the electron transport region) may comprise a metal-free compound comprising at least one π electron-deficient nitrogen-comprising C₁-C₆₀ cyclic group.

In an embodiment, the electron transport region may comprise a compound represented by Formula 601:

[Formula 601] [Ar601]xe11-[(L601)xe1-R601]xe21

In Formula 601,
Ar₆₀₁ and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each independently be the same as described in connection with Q₁,
xe21 may be 1, 2, 3, 4, or 5, and
at least one of Ar₆₀₁, L₆₀₁, and R₆₀₁ may each independently be a π electron-deficient nitrogen-comprising C₁-C₆₀ cyclic group that is unsubstituted or substituted with at least one R₁₀ₐ.

In an embodiment, in Formula 601, when xe11 is 2 or more, two or more of Ar₆₀₁ may be linked together via a single bond.

In an embodiment, in Formula 601, Ar₆₀₁ may be a substituted or unsubstituted anthracene group.

In an embodiment, the electron transport region may comprise a compound represented by Formula 601-1:

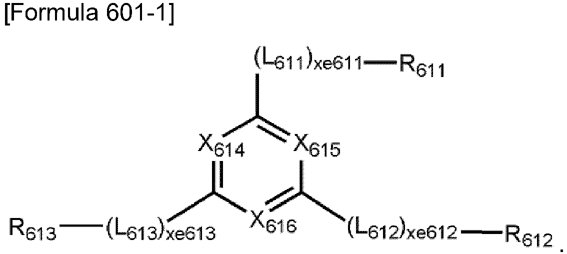

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may each be N,
L₆₁₁ to L₆₁₃ may each independently be the same as described in connection with L601,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In an embodiment, in Formulae 601 and 601-1, xe1 and xe611 to xe613 may each independently be 0, 1, or 2.

In an embodiment, the electron transport region may comprise one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

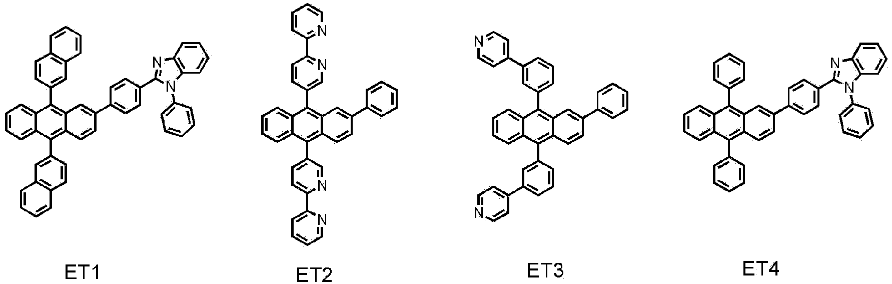

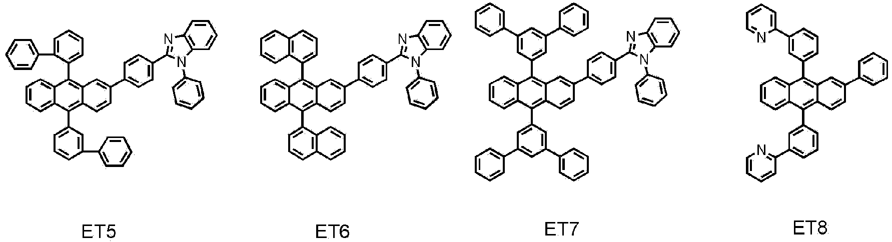

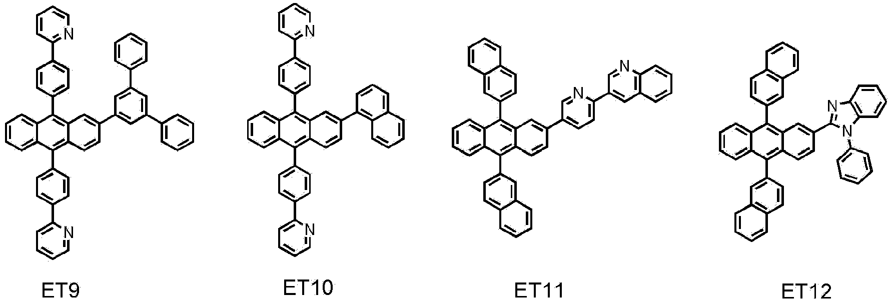

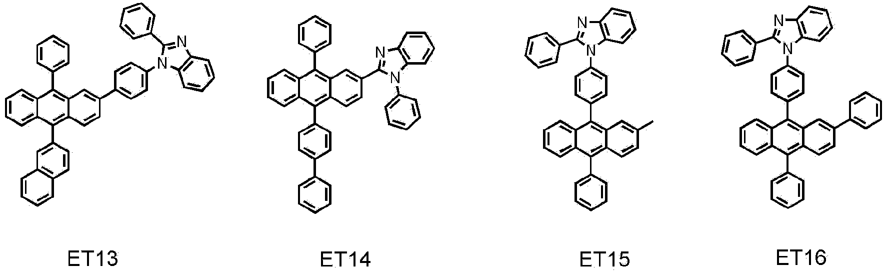

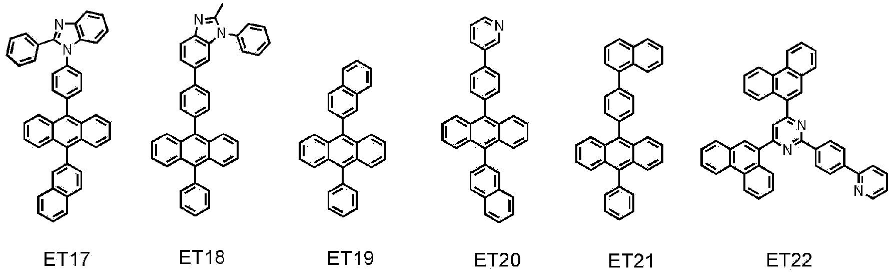

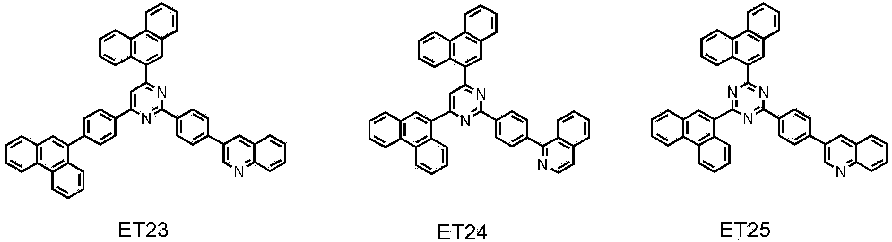

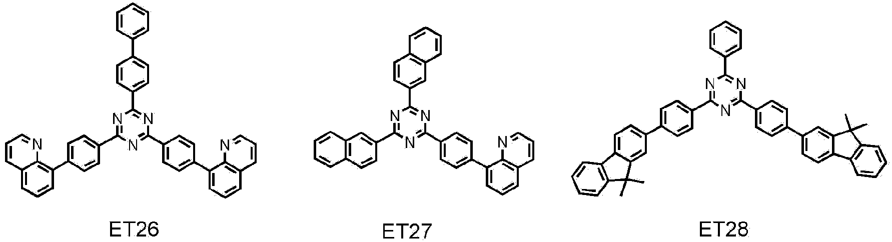

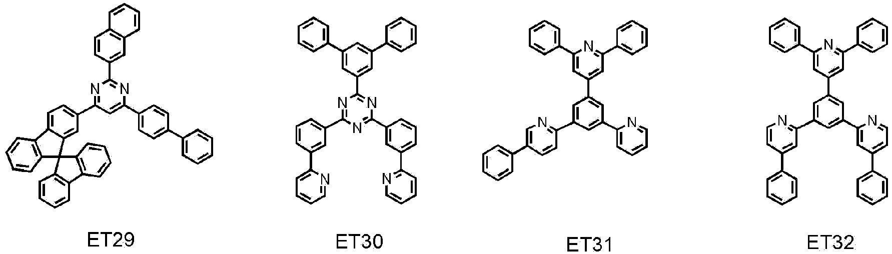

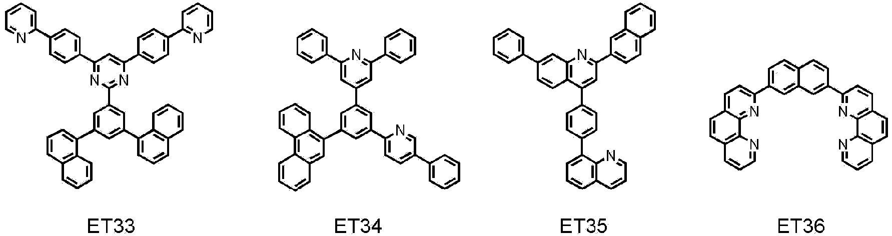

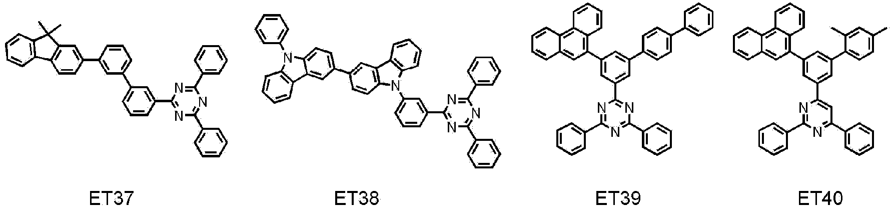

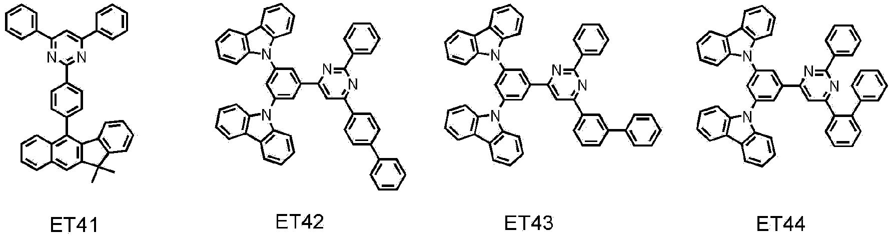

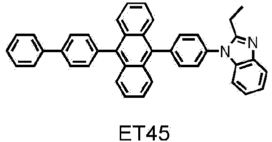

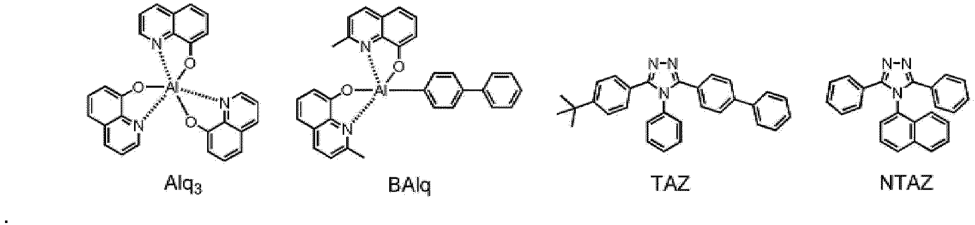

A thickness of the electron transport region may be in a range of about 100 Å to about 5,000 Å. For example, the thickness of the electron transport region may be in a range of about 160 Å to about 4,000 Å. When the electron transport region comprises a hole-blocking layer, an electron transport layer, or a combination thereof, a thickness of the hole-blocking layer may be in a range of about 20 Å to about 1,000 Å, and a thickness of the electron transport layer may be in a range of about 100 Å to about 1,000 Å. For example, the thickness of the hole-blocking layer may be in a range of about 30 Å to about 300 Å. For example, the thickness of the electron transport layer may be in a range of about 150 Å to about 500 Å. When the thicknesses of the hole-blocking layer, the electron transport layer, and/or the electron transport region are within the ranges described above, satisfactory electron transporting characteristics may be obtained without a substantial increase in driving voltage.

The electron transport region (for example, an electron transport layer in the electron transport region) may further comprise, in addition to the materials described above, a metal-containing material.

The metal-containing material may comprise an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion.

A ligand coordinated with a metal ion of an alkali metal complex or with a metal ion of an alkaline earth-metal complex may each independently comprise a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may comprise a Li complex. The Li complex may comprise, for example, Compound ET-D1 (LiQ) or Compound ET-D2:

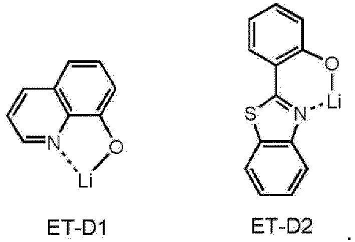

The electron transport region may comprise an electron injection layer that facilitates the injection of electrons from the second electrode 150. The electron injection layer may directly contact the second electrode 150.

The electron injection layer may have a structure consisting of a layer consisting of a single material, a structure consisting of a layer comprising different materials, or a structure comprising multiple layers comprising different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may comprise Li, Na, K, Rb, Cs, or any combination thereof. The alkaline earth metal may comprise Mg, Ca, Sr, Ba, or any combination thereof. The rare earth metal may comprise Sc, Y, Ce, Tb, Yb, Gd, or any combination thereof.

The alkali metal-containing compound, the alkaline earth metal-containing compound, and the rare earth metal-containing compound may comprise oxides, halides (for example, fluorides, chlorides, bromides, iodides, etc.), or tellurides of the alkali metal, the alkaline earth metal, and the rare earth metal, or any combination thereof.

The alkali metal-containing compound may comprise: an alkali metal oxide, such as Li₂O, Cs₂O, or K₂O; an alkali metal halide, such as LiF, NaF, CsF, KF, LiI, NaI, CsI, or KI; or any combination thereof. The alkaline earth metal-containing compound may comprise an alkaline earth metal oxide, such as BaO, SrO, CaO, BaₓSr₁₋ₓO (wherein x is a real number satisfying 0<x<1), or BaₓCa₁₋ₓO (wherein x is a real number satisfying 0<x<1). The rare earth metal-containing compound may comprise YbF₃, ScF₃, Sc₂O₃, Y₂O₃, Ce₂O₃, GdF₃, TbF₃, YbI₃, ScI₃, TbI₃, or any combination thereof. In an embodiment, the rare earth metal-containing compound may comprise a lanthanide metal telluride. Examples of a lanthanide metal telluride may comprise LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may comprise: an alkali metal ion, an alkaline earth metal ion, or a rare earth metal ion; and a ligand bonded to the metal ion (for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof).

In an embodiment, the electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In an embodiment, the electron injection layer may further comprise an organic material (for example, a compound represented by Formula 601).

In an embodiment, the electron injection layer may consist of an alkali metal-containing compound (for example, an alkali metal halide); or the electron injection layer may consist of an alkali metal-containing compound (for example, an alkali metal halide), and an alkali metal, an alkaline earth metal, a rare earth metal, or a combination thereof. For example, the electron injection layer may be a KI:Yb co-deposited layer, an RbI:Yb co-deposited layer, or the like.

When the electron injection layer further comprises an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly or non-uniformly dispersed in a matrix comprising the organic material.

A thickness of the electron injection layer may be in a range of about 1 Å to about 100 Å. For example, the thickness of the electron injection layer may be in a range of about 3 Å to about 90 Å. When the thickness of the electron injection layer is within any of the ranges described above, satisfactory electron injection characteristics may be obtained without a substantial increase in driving voltage.

### [Second electrode 150]

The second electrode 150 is arranged on the interlayer 130. The second electrode 150 may be a cathode, which is an electron injection electrode. When the second electrode 150 is a cathode, a material for forming the second electrode 150 may comprise a material having a low-work function, such as a metal, an alloy, an electrically conductive compound, or any combination thereof.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a transflective electrode, or a reflective electrode.

The second electrode 150 may have a single-layer structure or a multilayered structure.

### [Capping layer]

The light-emitting device 10 may comprise a first capping layer arranged outside the first electrode 110, and/or a second capping layer arranged outside the second electrode 150. In embodiments, the light-emitting device 10 may have a structure in which the first capping layer, the first electrode 110, the interlayer 130, and the second electrode 150 are stacked in the stated order, a structure in which the first electrode 110, the interlayer 130, the second electrode 150, and the second capping layer are stacked in the stated order, or a structure in which the first capping layer, the first electrode 110, the interlayer 130, the second electrode 150, and the second capping layer are stacked in the stated order.

Light generated in an emission layer of the interlayer 130 of the light-emitting device 10 may be extracted through the first electrode 110, which may be a transflective electrode or a transmissive electrode, and through the first capping layer to the outside. Light generated in an emission layer of the interlayer 130 of the light-emitting device 10 may be extracted through the second electrode 150, which may be a transflective electrode or a transmissive electrode, and through the second capping layer to the outside.

The first capping layer and the second capping layer may each increase external emission efficiency according to the principle of constructive interference. Accordingly, light extraction efficiency of the light-emitting device 10 may be increased, so that the luminescence efficiency of the light-emitting device 10 may be improved.

The first capping layer and the second capping layer may each comprise a material having a refractive index equal to or greater than about 1.6 (with respect to a wavelength of about 589 nm).

The first capping layer and the second capping layer may each independently be an organic capping layer comprising an organic material, an inorganic capping layer comprising an inorganic material, or an organic-inorganic composite capping layer comprising an organic material and an inorganic material.

At least one of the first capping layer and the second capping layer may each independently comprise a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be optionally substituted with a substituent comprising O, N, S, Se, Si, F, Cl, Br, I, or any combination thereof.

In an embodiment, at least one of the first capping layer and the second capping layer may each independently comprise an amine group-containing compound.

In an embodiment, at least one of the first capping layer and the second capping layer may each independently comprise a compound represented by Formula 201, a compound represented by Formula 202, or any combination thereof.

In an embodiment, at least one of the first capping layer and the second capping layer may each independently comprise one of Compounds HT28 to HT33, one of Compounds CP1 to CP6, β-NPB, or any combination thereof:

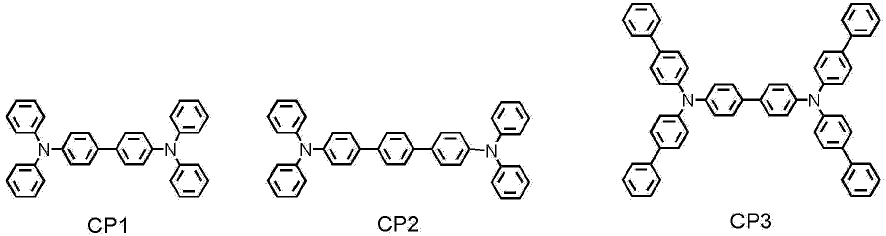

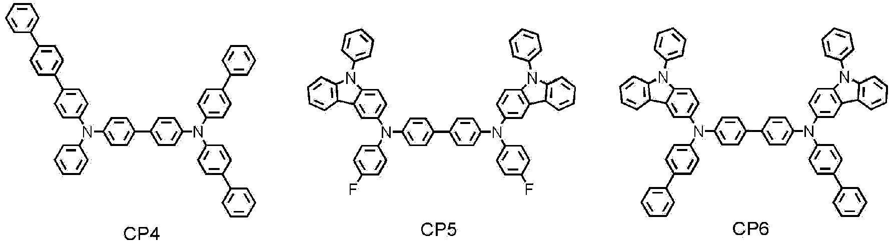

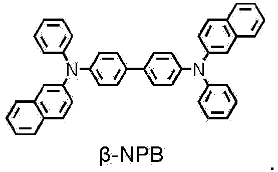

### [Electronic apparatus]

The light-emitting device may be comprised in various electronic apparatuses. For example, an electronic apparatus comprising the light-emitting device may be a light-emitting apparatus, an authentication apparatus, or the like.

The electronic apparatus (for example, a light-emitting apparatus) may further comprise a color filter, a color conversion layer, or a color filter and a color conversion layer, in addition to the light-emitting device. The color filter and/or the color conversion layer may be disposed in at least one traveling direction of light emitted from the light-emitting device. For example, light emitted from the light-emitting device may be blue light or white light. A further description of the light-emitting device may be the same as described above.

The electronic apparatus may comprise a substrate. The substrate may comprise subpixels, the color filter may comprise color filter regions respectively corresponding to the subpixels, and the color conversion layer may comprise color conversion regions respectively corresponding to the subpixels.

A pixel defining layer may be disposed between the subpixels to define each subpixel.

The color filter may further comprise color filter regions and light blocking patterns disposed between the color filter regions, and the color conversion layer may further comprise color conversion regions and light blocking patterns disposed between the color conversion regions.

The color filter regions (or the color conversion regions) may comprise a first region that emits first color light, a second region that emits second color light, and/or a third region that emits third color light, and the first color light, the second color light, and/or the third color light may have different maximum emission wavelengths. For example, the first color light may be red light, the second color light may be green light, and the third color light may be blue light. In an embodiment, the color filter regions (or the color conversion regions) may comprise quantum dots. For example, the first region may comprise a red quantum dot, the second region may comprise a green quantum dot, and the third region may not comprise a quantum dot. Further descriptions of the quantum dot may be the same as described herein. The first region, the second region, and/or the third region may each further comprise a scatterer.

The regions comprising a quantum dot may be formed using a quantum dot composition that comprises a quantum dot complex according to an embodiment.

In an embodiment, the light-emitting device may emit first light, the first region may absorb the first light to emit first-first color light, the second region may absorb the first light to emit second-first color light, and the third region may absorb the first light to emit third-first color light. The first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further comprise a thin film transistor (TFT), in addition to the light-emitting device as described above. The thin-film transistor may comprise a source electrode, a drain electrode, and an active layer, wherein any one of the source electrode and the drain electrode may be electrically connected to any one of the first electrode and the second electrode of the light-emitting device.

The TFT may further comprise a gate electrode, a gate insulating film, and the like.

The active layer may comprise crystalline silicon, amorphous silicon, an organic semiconductor, an oxide semiconductor, or the like.

The electronic apparatus may further comprise an encapsulation part that seals the light-emitting device. The encapsulation part may be disposed between the color filter and/or the color conversion layer and the light-emitting device. The encapsulation part may allow light from the light-emitting device to be emitted to the outside and while blocking ambient air and moisture from permeating into the light-emitting device. The encapsulation part may be an encapsulation substrate comprising a transparent glass substrate or a plastic substrate. The encapsulation part may be a thin film encapsulation layer that comprises at least one of an organic layer and/or an inorganic layer. When the encapsulation part is a thin film encapsulation layer, the electronic apparatus may be flexible.

Various functional layers may be further comprised on the encapsulation part, in addition to the color filter and/or the color conversion layer, according to a use of the electronic apparatus. Examples of a functional layer may comprise a touch screen layer, a polarization layer, and the like. The touch screen layer may be a resistive touch screen layer, a capacitive touch screen layer, or an infrared touch screen layer. The authentication apparatus may be, for example, a biometric authentication apparatus that authenticates an individual by using biometric information of a living body (for example, fingertips, pupils, etc.).

The authentication apparatus may further comprise a biometric information collecting unit, in addition to the light-emitting device described above.

The electronic apparatus may be applied to various displays, a light source, an illuminator, a personal computer (for example, a laptop computer), a mobile phone, a digital camera, an electronic notebook, an electronic dictionary, an electronic game machine, a medical apparatus (for example, an electronic thermometer, a blood pressure monitor, a blood glucose meter, a pulse measuring apparatus, a pulse wave measuring apparatus, an electrocardiogram display apparatus, an ultrasonic diagnostic apparatus, or an endoscope display apparatus), a fish detector, various measuring apparatuses, instruments (for example, instruments for vehicles, aircrafts, or ships), a projector, or the like.

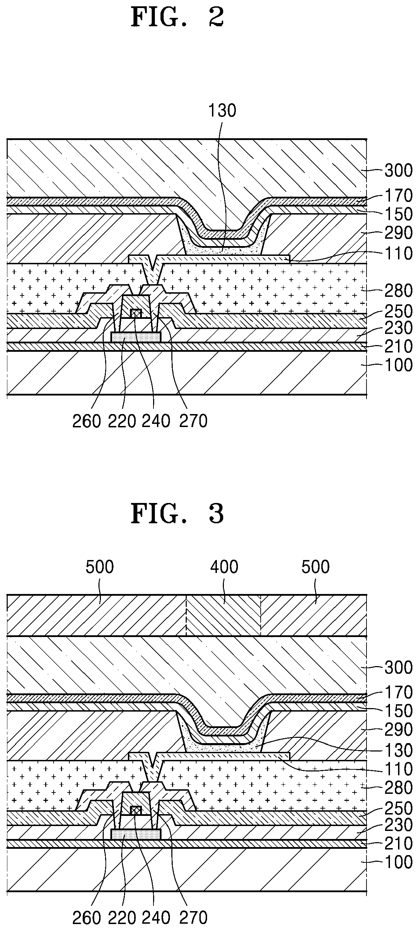

### [Description of FIGS. 2 and 3]

FIG. 2 is a schematic cross-sectional view of an electronic apparatus according to an embodiment.

The electronic apparatus of FIG. 2 may comprise a substrate 100, a thin film transistor (TFT), a light-emitting device, and an encapsulation part 300 that seals the light-emitting device.

The substrate 100 may be a flexible substrate, a glass substrate, or a metal substrate. A buffer layer 210 may be disposed on the substrate 100. The buffer layer 210 may prevent penetration of impurities through the substrate 100 and may provide a flat surface on the substrate 100.

The TFT may be disposed on the buffer layer 210. The TFT may comprise an active layer 220, a gate electrode 240, a source electrode 260, and a drain electrode 270.

The active layer 220 may comprise an inorganic semiconductor such as silicon or polysilicon, an organic semiconductor, or an oxide semiconductor, and may comprise a source region, a drain region, and a channel region.

A gate insulating film 230 may be disposed on the active layer 220 to insulate the active layer 220 from the gate electrode 240, and the gate electrode 240 may be disposed on the gate insulating film 230.

An interlayer insulating film 250 may be disposed on the gate electrode 240. The interlayer insulating film 250 may be disposed between the gate electrode 240 and the source electrode 260 and between the gate electrode 240 and the drain electrode 270, to insulate the gate electrode 240 from the source electrode 260 and to insulate the gate electrode 240 from the drain electrode 270.

The source electrode 260 and the drain electrode 270 may be disposed on the interlayer insulating film 250. The interlayer insulating film 250 and the gate insulating film 230 may be formed to expose a source region and a drain region of the active layer 220, and the source electrode 260 and the drain electrode 270 may respectively contact the exposed portions of the source region and the drain region of the active layer 220.

The TFT may be electrically connected to the light-emitting device to drive the light-emitting device and may be covered and protected by a passivation layer 280. The passivation layer 280 may comprise an inorganic insulating layer, an organic insulating layer, or a combination thereof. The light-emitting device may be provided on the passivation layer 280. The light-emitting device may comprise a first electrode 110, an interlayer 130, and a second electrode 150.

The first electrode 110 may be disposed on the passivation layer 280. The passivation layer 280 may not completely cover the drain electrode 270 and may expose a region of the drain electrode 270. The first electrode 110 may be disposed to be connected (for example, electrically connected) to the exposed region of the drain electrode 270.

A pixel defining film 290 comprising an insulating material may be disposed on the first electrode 110. The pixel defining film 290 may expose a region of the first electrode 110, and the interlayer 130 may be formed on the exposed region of the first electrode 110. The pixel defining film 290 may be a polyimide or polyacrylic organic film. Although not illustrated in FIG. 2, at least a portion of the interlayer 130 may extend to an upper portion of the pixel defining film 290 to be provided in the form of a common layer.

The second electrode 150 may be disposed on the interlayer 130, and a capping layer 170 may be further comprised on the second electrode 150. The capping layer 170 may be formed to cover the second electrode 150.

The encapsulation part 300 may be disposed on the capping layer 170. The encapsulation part 300 may be disposed on the light-emitting device to protect the light-emitting device from moisture and/or oxygen. The encapsulation part 300 may comprise: an inorganic film comprising silicon nitride (SiNₓ), silicon oxide (SiOₓ), indium tin oxide, indium zinc oxide, or a combination thereof; an organic film comprising polyethylene terephthalate, polyethylene naphthalate, polycarbonate, polyimide, polyethylene sulfonate, polyoxymethylene, polyarylate, hexamethyldisiloxane, an acryl-based resin (for example, polymethyl methacrylate or a polyacrylic acid), an epoxy-based resin (for example, aliphatic glycidyl ether (AGE)), or a combination thereof; or a combination of an inorganic film and an organic film.

FIG. 3 is a schematic cross-sectional view of an electronic apparatus according to another embodiment.

The electronic apparatus of FIG. 3 may differ from the electronic apparatus of FIG. 2, at least in that a light blocking pattern 500 and a functional region 400 are further comprised on an encapsulation part 300. The functional region 400 may be a color filter region, a color conversion region, or a combination of a color filter region and a color conversion region. At least a portion of the functional region 400 may be formed using a quantum dot composition comprising a quantum dot complex according to an embodiment.

According to an embodiment, a light-emitting device comprised in the electronic apparatus of FIG. 3 may be a tandem light-emitting device.

### [Manufacturing method]

Each layer comprised in the hole transport region, the emission layer, each layer comprised in the electron transport region, and the like may be formed in selected regions using various methods such as vacuum deposition, spin coating, casting, a Langmuir-Blodgett (LB) method, ink-jet printing, laser-printing, and laser-induced thermal imaging (LITI).

The color filter region, the color conversion region, and the like may be formed in selected regions using spin coating, casting, ink-jet printing, or the like.

When each layer comprised in the hole transport region, the emission layer, and each layer comprised in the electron transport are each formed through vacuum deposition, the vacuum deposition may be performed at a deposition temperature in a range of about 100 °C to about 500 °C, a vacuum degree in a range of about 10-8 torr to about 10-3 torr, and a deposition rate in a range of about 0.01 Å/sec to about 100 Å/sec, in consideration of a material to be comprised in a layer to be formed and a structure of the layer to be formed.

When each layer comprised in the hole transport region, the emission layer, and each layer comprised in the electron transport are each formed through spin coating, the spin coating may be performed at a coating rate in a range of about 2,000 revolutions per minute (rpm) to about 5,000 rpm and a heat treatment temperature in a range of about 80 °C to about 200 °C, in consideration of a material to be comprised in a layer to be formed and a structure of the layer to be formed.

A quantum dot composition according to an embodiment may be used in a solution process comprising spin coating, ink-jet printing, or the like.

### [Definitions of terms]

The term "C₃-C₆₀ carbocyclic group" as used herein may be a cyclic group consisting of carbon atoms as the only ring-forming atoms and having three to sixty carbon atoms. The term "C₁-C₆₀ heterocyclic group" as used herein may be a cyclic group that has one to sixty carbon atoms and further comprises, in addition to the carbon atoms, at least one heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. In an embodiment, the number of ring-forming atoms in a C₁-C₆₀ heterocyclic group may be 3 to 61.

The term "cyclic group" as used herein may be a C₃-C₆₀ carbocyclic group or a C₁-C₆₀ heterocyclic group.

The term "π electron-rich C₃-C₆₀ cyclic group" as used herein may be a cyclic group that has three to sixty carbon atoms and may not comprise *-N=*' as a ring-forming moiety. The term "π electron-deficient nitrogen-comprising C₁-C₆₀ cyclic group" as used herein may be a heterocyclic group that has one to sixty carbon atoms and may comprise *-N=*' as a ring-forming moiety.

In an embodiment,
a C₃-C₆₀ carbocyclic group may be a T1 group or a group in which two or more T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
a C₁-C₆₀ heterocyclic group may be a T2 group, a group in which two or more T2 groups are condensed with each other, or a group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
a π electron-rich C₃-C₆₀ cyclic group may be a T1 group, a group in which two or more T1 groups are condensed with each other, a T3 group, a group in which two or more T3 groups are condensed with each other, or a group in which at least one T3 group and at least one T1 group are condensed with each other (for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),
a π electron-deficient nitrogen-comprising C₁-C₆₀ cyclic group may be a T4 group, a group in which two or more T4 groups are condensed with each other, a group in which at least one T4 group and at least one T1 group are condensed with each other, a group in which at least one T4 group and at least one T3 group are condensed with each other, or a group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like), wherein
a T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
a T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
a T3 group may be a furan group, a thiophene group, a 1H-pyrrole group, a silole group, or a borole group, and
a T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group," "C₃-C₆₀ carbocyclic group," "C₁-C₆₀ heterocyclic group," "π electron-rich C₃-C₆₀ cyclic group," and "π electron-deficient nitrogen-comprising C₁-C₆₀ cyclic group" as used herein may each be a group condensed to any cyclic group, a monovalent group, or a polyvalent group (for example, a divalent group, a trivalent group, a tetravalent group, etc.) according to the structure of a formula for which the corresponding term is used. For example, a "benzene group" may be a benzo group, a phenyl group, a phenylene group, or the like, which may be readily understood by one of ordinary skill in the art according to the structure of a formula comprising the "benzene group."

Examples of a monovalent C₃-C₆₀ carbocyclic group or a monovalent C₁-C₆₀ heterocyclic group may comprise a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of a divalent C₃-C₆₀ carbocyclic group or a divalent C₁-C₆₀ heterocyclic group may comprise a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein may be a linear or branched monovalent aliphatic hydrocarbon group that has one to sixty carbon atoms, and examples thereof may comprise a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein may be a divalent group having a same structure as the C₁-C₆₀ alkyl group.

The term "C₂-C₆₀ alkenyl group" as used herein may be a monovalent hydrocarbon group having at least one carbon-carbon double bond in the middle or at a terminus of a C₂-C₆₀ alkyl group, and examples thereof may comprise an ethenyl group, a propenyl group, and a butenyl group. The term "C₂-C₆₀ alkenylene group" as used herein may be a divalent group having a same structure as the C₂-C₆₀ alkenyl group.

The term "C₂-C₆₀ alkynyl group" as used herein may be a monovalent hydrocarbon group having at least one carbon-carbon triple bond in the middle or at a terminus of a C₂-C₆₀ alkyl group, and examples thereof may comprise an ethynyl group and a propynyl group. The term "C₂-C₆₀ alkynylene group" as used herein may be a divalent group having a same structure as the C₂-C₆₀ alkynyl group.

The term "C₁-C₆₀ alkoxy group" as used herein may be a monovalent group represented by -O(A₁₀₁) (wherein A₁₀₁ may be a C₁-C₆₀ alkyl group), and examples thereof may comprise a methoxy group, an ethoxy group, and an isopropyloxy group.

The term "C₃-C₁₀ cycloalkyl group" as used herein may be a monovalent saturated hydrocarbon cyclic group having 3 to 10 carbon atoms, and examples thereof may comprise a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein may be a divalent group having a same structure as the C₃-C₁₀ cycloalkyl group.

The term "C₁-C₁₀ heterocycloalkyl group" as used herein may be a monovalent cyclic group that has one to ten carbon atoms and further comprises, in addition to the carbon atoms, at least one heteroatom as a ring-forming atom, and examples thereof may comprise a 1,2,3,4-oxatriazolidinyl group, a tetrahydrofuranyl group, and a tetrahydro thiophenyl group. The term "C₁-C₁₀ heterocycloalkylene group" as used herein may be a divalent group having a same structure as the C₁-C₁₀ heterocycloalkyl group.

The term "C₃-C₁₀ cycloalkenyl group" as used herein may be a monovalent cyclic group that has three to ten carbon atoms and at least one carbon-carbon double bond in the cyclic structure thereof and no aromaticity, and examples thereof may comprise a cyclopentenyl group, a cyclohexenyl group, and a cycloheptenyl group. The term "C₃-C₁₀ cycloalkenylene group" as used herein may be a divalent group having a same structure as the C₃-C₁₀ cycloalkenyl group.

The term "C₁-C₁₀ heterocycloalkenyl group" as used herein may be a monovalent cyclic group that has one to ten carbon atoms, further comprising, in addition to the carbon atoms, at least one heteroatom as a ring-forming atom, and has at least one double bond in the cyclic structure thereof. Examples of a C₁-C₁₀ heterocycloalkenyl group may comprise a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein may be a divalent group having a same structure as the C₁-C₁₀ heterocycloalkenyl group.

The term "C₆-C₆₀ aryl group" as used herein may be a monovalent group having a carbocyclic aromatic system of six to sixty carbon atoms, and the term "C₆-C₆₀ arylene group" as used herein may be a divalent group having a carbocyclic aromatic system of six to sixty carbon atoms. Examples of a C₆-C₆₀ aryl group may comprise a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each comprise two or more rings, the respective two or more rings may be condensed with each other.

The term "C₁-C₆₀ heteroaryl group" as used herein may be a monovalent group having a heterocyclic aromatic system that has one to sixty carbon atoms and further comprises, in addition to the carbon atoms, at least one heteroatom as a ring-forming atom. The term "C₁-C₆₀ heteroarylene group" as used herein may be a divalent group having a heterocyclic aromatic system that has one to sixty carbon atoms and further comprises, in addition to the carbon atoms, at least one heteroatom as a ring-forming atom. Examples of a C₁-C₆₀ heteroaryl group may comprise a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each comprise two or more rings, the respective two or more rings may be condensed with each other.

The term "monovalent non-aromatic condensed polycyclic group" as used herein may be a monovalent group having two or more rings condensed with each other, only carbon atoms (for example, eight to sixty carbon atoms) as ring-forming atoms, and no aromaticity in its molecular structure as a whole. Examples of a monovalent non-aromatic condensed polycyclic group may comprise an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as used herein may be a divalent group having a same structure as the monovalent non-aromatic condensed polycyclic group.

The term "monovalent non-aromatic condensed heteropolycyclic group" as used herein may be a monovalent group that has two or more rings condensed with each other, further comprising, in addition to carbon atoms (for example, one to sixty carbon atoms), at least one heteroatom as a ring-forming atom, and has no aromaticity in its molecular structure as a whole. Examples of a monovalent non-aromatic condensed heteropolycyclic group may comprise a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothienyl group. The term "divalent non-aromatic condensed heteropolycyclic group" as used herein may be a divalent group having a same structure as the monovalent non-aromatic condensed heteropolycyclic group.

The term "C₆-C₆₀ aryloxy group" as used herein may be a group represented by - O(A₁₀₂) (wherein A₁₀₂ may be a C₆-C₆₀ aryl group), and the term "C₆-C₆₀ arylthio group" as used herein may be a group represented by -S(A₁₀₃) (wherein A₁₀₃ may be a C₆-C₆₀ aryl group).

The term "C₇-C₆₀ arylalkyl group" as used herein may be a group represented by -(A₁₀₄)(A₁₀₅) (wherein A₁₀₄ may be a C₁-C₅₄ alkylene group, and A₁₀₅ may be a C₆-C₅₉ aryl group), and the term "C₂-C₆₀ heteroarylalkyl group" as used herein may be a group represented by -(A₁₀₆)(A₁₀₇) (wherein A₁₀₆ may be a C₁-C₅₉ alkylene group, and A₁₀₇ may be a C₁-C₅₉ heteroaryl group).

In the specification, the group "R₁₀ₐ" may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), -C(=O)(Q₁₁),-S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁),-P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or-P(=O)(Q₃₁)(Q₃₂).

In the specification, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group, a C₁-C₆₀ heterocyclic group, a C₇-C₆₀ arylalkyl group, or a C₂-C₆₀ heteroaryl alkyl group, each substituted with deuterium, -F, a cyano group, a C₁-C₆₀ alkyl group, a C₁-C₆₀ alkoxy group, a phenyl group, a biphenyl group, or a combination thereof.

The term "heteroatom" as used herein may be any atom other than a carbon atom or a hydrogen atom. Examples of a heteroatom may comprise O, S, N, P, Si, B, Ge, Se, and any combination thereof.

In the specification, examples of a "third-row transition metal" may comprise hafnium (Hf), tantalum (Ta), tungsten (W), rhenium (Re), osmium (Os), iridium (Ir), platinum (Pt), gold (Au), and the like.

In the specification, the term "Ph" refers to a phenyl group, the term "Me" refers to a methyl group, the term "Et" refers to an ethyl group, the terms "ter-Bu" and "Bu^{t}" each refers to a tert-butyl group, and the term "OMe" refers to a methoxy group.

The term "biphenyl group" as used herein may be a "phenyl group substituted with a phenyl group." For example, a "biphenyl group" may be a substituted phenyl group having a C₆-C₆₀ aryl group as a substituent.

The term "terphenyl group" as used herein may be a "phenyl group substituted with a biphenyl group". For example, a "terphenyl group" may be a substituted phenyl group having, as a substituent, a C₆-C₆₀ aryl group substituted with a C₆-C₆₀ aryl group.

In the definitions of the substituents described above, the maximum number of carbon atoms in the definition of a substituent is listed only as an example. For example, the number 60 as the maximum number of carbon atoms in the definition of a C₁-C₆₀ alkyl group is only an example, and the definition of an alkyl group may also be equally applied to a C₁-C₂₀ alkyl group. The other cases may be the same.

In the specification, the symbols * and *' as used herein each refer to a bonding site to a neighboring atom in a corresponding formula or moiety, unless defined otherwise.

Hereinafter, a compound and a light-emitting device, each according to an embodiment, will be described in detail with reference to the following Examples.

### [Examples]

### Experimental Example 1 (native ligand)

CuI, GaI₃, and InI₃ were added to a 3-neck flask at a molar ratio of 2:5:4, and oleylamine (OLA) and trioctylamine (TOA), which are a solvent and a ligand, were added at a 1:1 ratio and stirred (first solution). The first solution was degassed under vacuum conditions at 120 °C for 30 minutes. Separately, a 1M precursor solution (S-OLA solution) was prepared by dissolving sulfur (S) powder in OLA. The prepared S-OLA solution was injected into the first solution under N₂ conditions at 120 °C. In this regard, the total injection amount of S precursor was three times the Ga ratio. The temperature of the mixed solution was raised to 230 °C and a reaction proceeded for 2 hours to synthesize the CIGS core.

At a temperature of 120 °C and under N₂ atmosphere, a zinc oleate (ZnOA) solution dissolved in TOA, and a TOP-S solution were each separately added to the synthesized CIGS core at an amount of 1.5 times that of the Group III element (In+Ga) added when the CIGS core was synthesized. After the temperature was raised to 260 °C, the reaction proceeded for 1 hour. The surface of the quantum dot was post-treated with dodecane thiol (DDT) and trioctyl phosphine (TOP) solutions, and the reaction was terminated. Ethanol was added to the CIGS/ZnS quantum dot solution and centrifuged at 9,000 rpm. The centrifuged quantum dot was dispersed in toluene, ethanol was added thereto again, and the centrifugation process was performed one more time, and dried and dissolved in cyclohexyl acetate (CHA).

### Experimental Example 2 (Ligand Exchange)

A CIGS quantum dot solution (1.0 g in 2.36 mL of cyclohexyl acetate) synthesized in Experimental Example 1 in which oleic acid was coordinated as the native ligand, was mixed with the compound MAS (0.23 g, 1 mmol) at 80 °C under a nitrogen atmosphere, and vigorously stirred for 3.5 hours to perform ligand exchange. To the quantum dot solution, hexane was added in an amount 10 times the weight of the solution and centrifuged (9,500 rpm for 3 min.), and the obtained precipitate was vacuum dried to obtain a quantum dot complex.

### Experimental Examples 3 to 7 (Ligand Exchange)

Quantum dot complexes were obtained using the same method as Experimental Example 1, except that Compounds L1 to L5 were used in the amounts shown in Table 1 (corresponding to 1 mmol) instead of 0.23 g of Compound MAS as the ligand exchange compound.

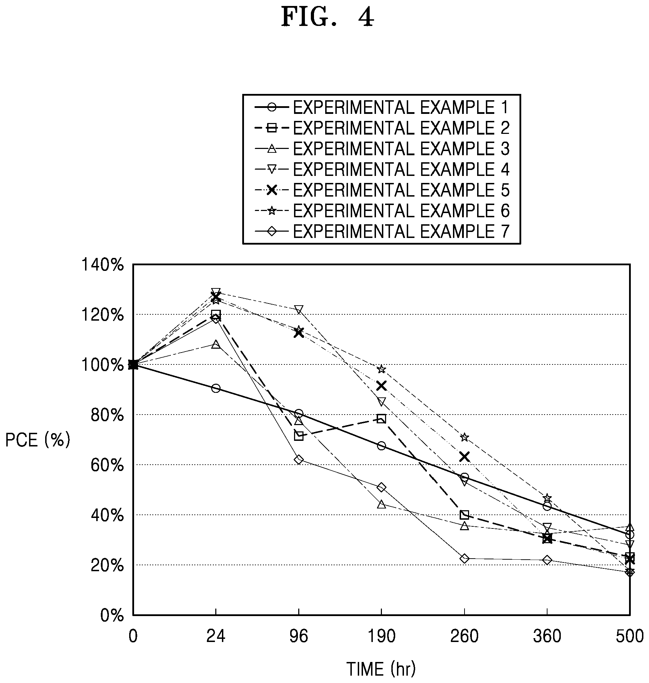

In order to evaluate light resistance, the photo conversion efficiency (PCE) of each of the quantum dot complexes of Experimental Examples 1 to 7 over time was measured. Results are shown in Table 1 and FIG. 4. The PCE was measured using a light source of a 460 nm on a sample having the size of 20 mm x 20 mm, by using Otsuka Electronics QE-2100 equipment. The PCE was expressed as a percentage based on the PCE at the time the light source began to be radiated to the quantum dot layer (0 hr).

**[Table 1]**

| | Ligand exchange Compound | 0 hr | 24 hr | 96 hr | 190 hr | 260 hr | 360 hr | 500 hr |
|---|---|---|---|---|---|---|---|---|
| Experimental Example 1 | - | 100.0% | 90.3% | 80.7% | 67.5% | 54.7% | 43.2% | 31.7% |
| Experimental Example 2 | MAS (1 mmol) | 100.0% | 119.7% | 71.2% | 78.3% | 39.8% | 30.9% | 23.2% |
| Experimental Example 3 | L1 (1 mmol) | 100.0% | 108.2% | 77.5% | 44.0% | 35.7% | 32.3% | 35.1% |
| Experimental Example 4 | L2 (1 mmol) | 100.0% | 128.4% | 121.9% | 85.1% | 53.0% | 34.7% | 27.8% |
| Experimental Example 5 | L3 (1 mmol) | 100.0% | 126.6% | 112.8% | 91.2% | 63.2% | 30.5 % | 22.1% |
| Experimental Example 6 | L4 (1 mmol) | 100.0% | 125.5% | 114.0% | 98.2% | 71.0% | 46.8% | 17.7% |
| Experimental Example 7 | L5 (1 mmol) | 100.0% | 118.0% | 62.1% | 50.9% | 22.5% | 21.8% | 16.7% |

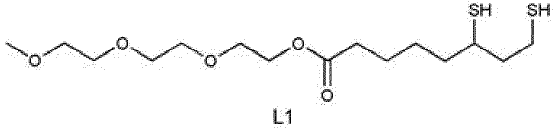

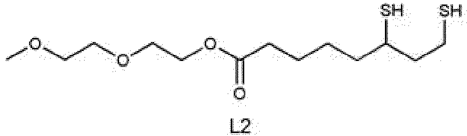

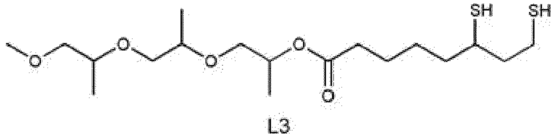

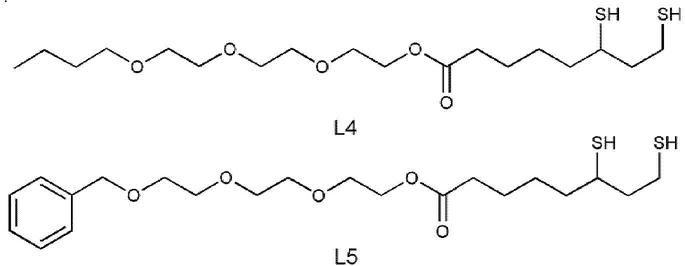

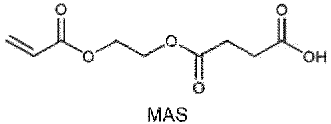

Referring to Table 1 and FIG. 4, in the case of Experimental Examples 6 and 7 using Compounds L4 and L5 as the ligand exchange material, the decrease in the PCE of the quantum dot complex over time was greatest.

### Example 1

A CIGS/ZnS quantum dot solution (1.0 g in 2.36 mL of cyclohexyl acetate) synthesized in Experimental Example 1 in which oleic acid was coordinated as the native ligand, was mixed with Compound MAS (0.23 g, 1 mmol) at 80 °C under a nitrogen atmosphere, and vigorously stirred for 3.5 hours to perform a first ligand exchange. Compound L1 (0.25 g, 0.7 mmol) was added to the quantum dot solution, of which the first ligand exchange was completed, at 80 °C under a nitrogen atmosphere and stirred vigorously for 3.5 hours to perform the second ligand exchange. To the quantum dot solution, hexane was added in an amount 10 times the weight of the solution and centrifuged (9,500 rpm for 3 min.), and the obtained precipitate was vacuum dried to obtain a quantum dot complex.

### Example 2

A quantum dot complex was obtained in the same manner as in Example 1, except that Compound L2 (0.22 g, 0.7 mmol) was used instead of Compound L1.

### Example 3

A quantum dot complex was obtained in the same manner as in Example 1, except that Compound L3 (0.28 g, 0.7 mmol) was used instead of Compound L1.

### Comparative Example 1

A quantum dot complex was obtained in the same method as Experimental Example 1, and no ligand exchange was performed.

### Comparative Example 2

A quantum dot complex was obtained in the same manner as in Example 1, except that Compound L4 (0.28 g, 0.7 mmol) was used instead of Compound L1.

### Comparative Example 3

A quantum dot complex was obtained in the same manner as in Example 1, except that Compound L5 (0.31 g, 0.7 mmol) was used instead of Compound L1.

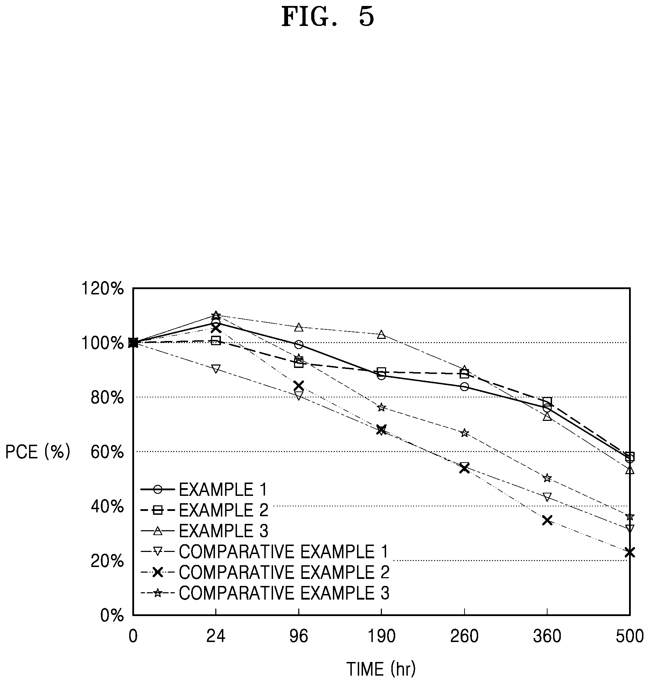

In order to evaluate light resistance, the PCE over time was measured for the quantum dot complexes of Examples 1 to 3 and Comparative Examples 1 to 3 by the method described above. Results thereof are shown in Table 2 and FIG. 5.

**[Table 2]**

| | Ligand exchange | 0 hr | 24 hr | 96 hr | 190 hr | 260 hr | 360 hr | 500 hr |
|---|---|---|---|---|---|---|---|---|
| Example 1 | MAS (1 mmol) + L1(0.7 mmol) | 100.0% | 107.1% | 99.4% | 88.0% | 83.8% | 76.0% | 57.4% |
| Example 2 | MAS (1 mmol) + L2(0.7 mmol) | 100.0% | 100.7% | 92.6% | 89.2% | 88.6% | 78.4% | 58.2% |
| Example 3 | MAS (1 mmol) + L3 (0.7 mmol) | 100.0% | 109.7% | 105.7% | 103.2% | 90.3% | 72.9% | 53.5% |
| Comparative Example 1 | - | 100.0% | 90.3% | 80.7% | 67.5% | 54.7% | 43.2% | 31.7% |
| Comparative Example 2 | MAS (1 mmol) + L4 (0.7 mmol) | 100.0% | 105.3% | 84.2% | 68.2% | 53.9% | 35.0% | 23.1% |
| Comparative Example 3 | MAS (1 mmol) + L5 (0.7 mmol) | 100.0% | 110.1% | 94.3% | 76.3% | 67.0% | 50.3% | 36.4% |

Referring to Table 2 and FIG. 5, the decrease over time in the light conversion efficiency of the quantum dot complexes of Examples 1 to 3 appears to be lower than the decrease over time in the light conversion efficiency of the quantum dot complexes of Comparative Examples 1 to 3. As a result, it can be seen that using Compounds L1 to L3 as a bidentate ligand (secondary ligand) is more advantageous for improving the light resistance of a quantum dot layer than using Compounds L4 or L5.

### Example 4

A quantum dot complex was obtained in the same manner as in Example 1, except that Compound L1 (0.13 g, 0.37 mmol) was used instead of Compound L1.

### Example 5

A quantum dot complex was obtained in the same manner as in Example 1, except that Compound L2 (0.11 g, 0.35mmol) was used instead of Compound L1.

### Example 6

A quantum dot complex was obtained in the same manner as in Example 1, except that Compound L3 (0.14 g, 0.35 mmol) was used instead of Compound L1.

### Comparative Example 4

A quantum dot complex was obtained in the same manner as in Example 1, except that Compound L1 (0.38 g, 1mmol) was used instead of Compound L1.

### Comparative Example 5

A quantum dot complex was obtained in the same manner as in Example 1, except that Compound L2 (0.33 g, 1mmol) was used instead of Compound L1.

### Comparative Example 6

A quantum dot complex was obtained in the same manner as in Example 1, except that Compound L3 (0.42 g, 1 mmol) was used instead of Compound L1.

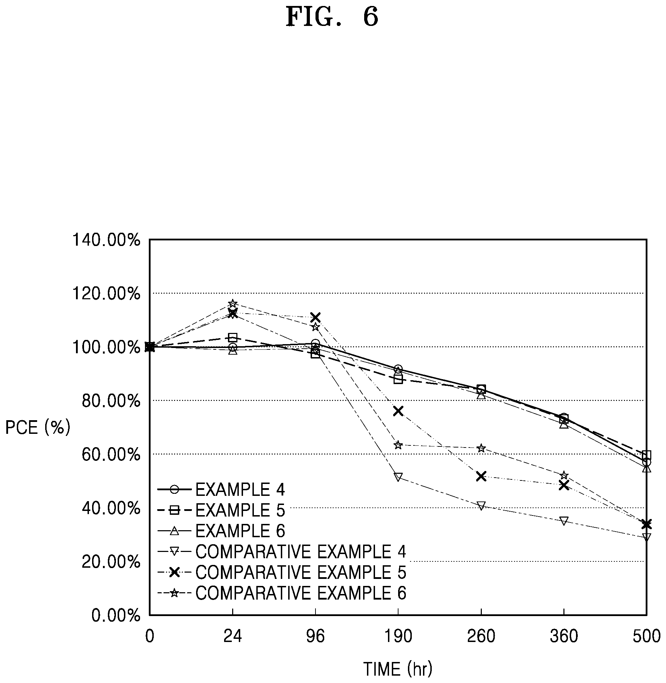

In order to evaluate light resistance, the light conversion efficiency (PCE) over time was measured for the quantum dot complexes of Examples 4 to 6 and Comparative Examples 4 to 6 by the method described above. Results thereof are shown in Table 3 and FIG. 6.

**[Table 3]**

| | Ligand exchange | 0 hr | 24 hr | 96 hr | 190 hr | 260 hr | 360 hr | 500 hr |
|---|---|---|---|---|---|---|---|---|
| Example 4 | MAS (1 mmol) + L1(0.37 mmol) | 100.0% | 99.8% | 101.2% | 91.5% | 83.7% | 73.7% | 57.1% |
| Example 5 | MAS (1 mmol) + L2 (0.35 mmol) | 100.0% | 103.1% | 97.5% | 88.0% | 83.8% | 73.1% | 59.4% |
| Example 6 | MAS (1 mmol) + L3 (0.35 mmol) | 100.0% | 98.7% | 99.2% | 90.7% | 82.1% | 71.1% | 54.7% |
| Comparative Example 4 | MAS (1 mmol) + L1 (1 mmol) | 100.0% | 112.0% | 98.8% | 51.5% | 40.4% | 35.0% | 29.0% |
| Comparative Example 5 | MAS (1 mmol) + L2 (1 mmol) | 100.0% | 112.5% | 110.7% | 75.8% | 51.6% | 48.4% | 33.8% |
| Comparative Example 6 | MAS (1 mmol) + L3 (1 mmol) | 100.0% | 115.9% | 107.4% | 63.2% | 62.0% | 52.3% | 33.9% |

Referring to Table 3 and FIG. 4, the decrease over time in the light conversion efficiency of the quantum dot complexes of Examples 4 to 6 appears to be lower than the decrease over time in the light conversion efficiency of the quantum dot complexes of Comparative Examples 4 to 6.

### Thermogravimetric analysis (TGA)

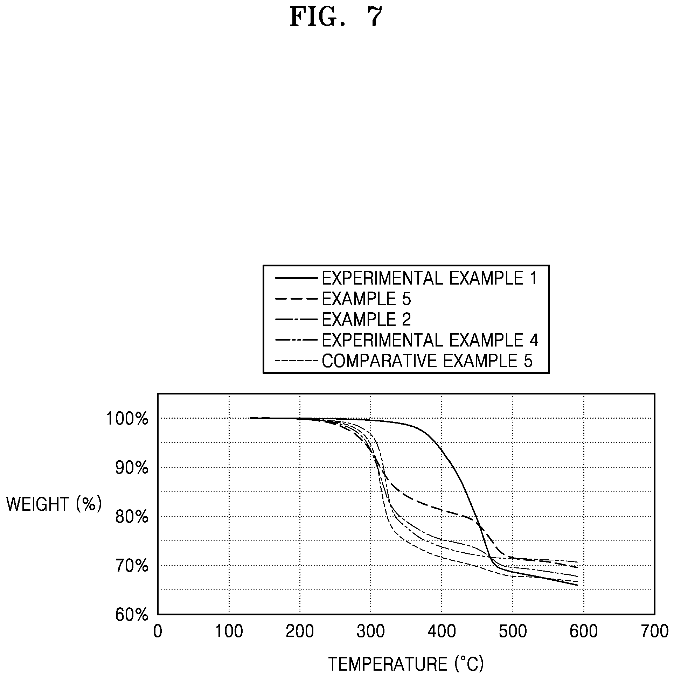

TGA was performed on the CIGS quantum dot complexes obtained in Experimental Examples 1 and 4, Examples 2 and 5, and Comparative Example 5. FIG. 7 is a thermogravimetric analysis graph for the CIGS quantum dot complexes obtained in Experimental Examples 1 and 4, Examples 2 and 5, and Comparative Example 5. Referring to FIG. 7, TGA showed that organic ligands accounted for about 30 wt% to about 34 wt%, based on 100 wt% of the total weight of the CIGS quantum dot complexes obtained in Experimental Examples 1 and 4, Examples 2 and 5, and Comparative Example 5.

Thermogravimetric analysis showed that the ratios of the combined weight of the MAS ligand and Compound L2 ligand to the weight of the native ligand in the CIGS quantum dot complexes of Examples 2 and 5, and Comparative Example 5 were 77:23, 62:38, and 86:14, respectively, and the ratio of the weight of Compound L2 to the weight of native ligand in the CIGS quantum dot complex of Experimental Example 4 was about 81:19.

## Claims

1. A quantum dot complex comprising:
a quantum dot; and
a first ligand and a second ligand, each coordinated on a surface of the quantum dot, wherein
the first ligand is a chain-shaped bidentate ligand comprising an ethylene glycol group (-OCH₂CH₂O-), and
the second ligand is a ligand comprising an acryloyl group (CH₂=CHC(=O)-) and an ethylene glycol group.

2. The quantum dot complex of claim 1, wherein the first ligand is represented by Formula 1: 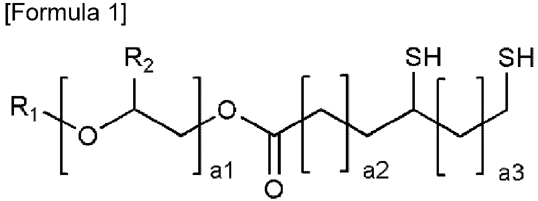 wherein in Formula 1,
R₁ is a C₁-C₂ alkyl group,
R₂ is each independently hydrogen or a C₁-C₂ alkyl group,
a1 is an integer from 2 to 4,
a2 is an integer from 0 to 3, and
a3 is an integer of 1 or 2.

3. The quantum dot complex of claim 2, wherein
R₁ is a methyl group, and
R₂ is each independently hydrogen or a methyl group.

4. The quantum dot complex of claim 2, wherein
R₁ is a methyl group, and
R₂ is each hydrogen.

5. The quantum dot complex of claim 2, wherein R₁ and R₂ are each a methyl group.

6. The quantum dot complex of claim 2, wherein a1 is 2 or 3.

7. The quantum dot complex of claim 2, wherein
a2 is 3, and
a3 is 1.

8. The quantum dot complex of claim 1, wherein the first ligand is selected from the following compounds:

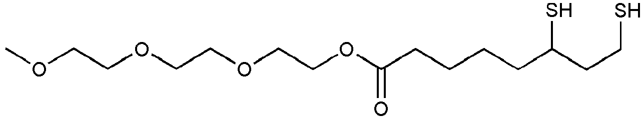

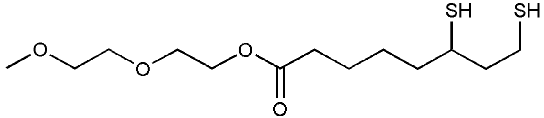

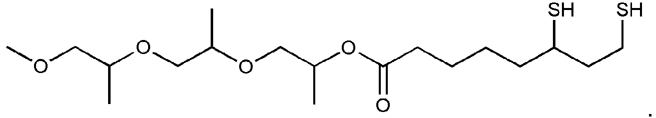

9. The quantum dot complex of claim 1, wherein
the second ligand further comprises a carboxylate group (-C(=O)OH) group, and
the second ligand is coordinated on the surface of the quantum dot by the carboxylate group.

10. The quantum dot complex of claim 1, wherein the second ligand comprises the following compound:

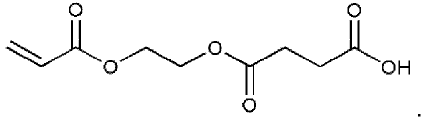

11. The quantum dot complex of claim 1, wherein a total amount of the first ligand and the second ligand is in a range of about 15 wt% to about 25 wt%, based on a total weight of the quantum dot complex.

12. The quantum dot complex of claim 1, wherein a molar ratio of the first ligand to the second ligand is in a range of about 0.3:1 to about 0.8:1.

13. The quantum dot complex of claim 1, wherein the quantum dot comprises:
a Group II-VI semiconductor compound; a Group III-V semiconductor compound; a Group III-VI semiconductor compound; a Group I-III-VI semiconductor compound; a Group IV-VI semiconductor compound; a Group IV element or compound; or a combination thereof.

14. The quantum dot complex of claim 1, wherein the quantum dot comprises:
a core; and
a shell covering the core.

15. The quantum dot complex of claim 1, wherein the quantum dot comprises:
a copper indium gallium sulfide (CIGS) core; and
a ZnS shell.

16. A quantum dot composition comprising:
the quantum dot complex of any one of claims 1 to 15; and
a solvent.

17. An electronic device comprising the quantum dot complex of claim 1.

18. The electronic device of claim 17, further comprising:
a color filter and/or a color conversion layer, wherein
the color filter and/or the color conversion layer comprises the quantum dot complex.

19. The electronic device of claim 18, further comprising:
a light source, wherein
the light source is a light-emitting device comprising:
a first electrode;
a second electrode facing the first electrode; and
an emission layer between the first electrode and the second electrode.

20. An electronic equipment comprising:
the electronic device of claim 19, wherein
the electronic equipment is a flat panel display, a curved display, a computer monitor, a medical monitor, a television, an advertisement board, an indoor light, an outdoor light, a signal light, a head-up display, a fully transparent display, a partially transparent display, a flexible display, a rollable display, a foldable display, a stretchable display, a laser printer, a telephone, a mobile phone, a tablet computer, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall comprising multiple displays tiled together, a theater screen, a stadium screen, a phototherapy device, or a signboard.
